(19) Europäisches Patentamt / European Patent Office / Office européen des brevets

(11) **EP 2 873 133 B1**

(12) **FASCICULE DE BREVET EUROPEEN**

(45) Date de publication et mention de la délivrance du brevet:
**25.05.2016 Bulletin 2016/21**

(21) Numéro de dépôt: **13732594.0**

(22) Date de dépôt: **02.07.2013**

(51) Int Cl.:
*G01R 31/36* (2006.01)     *G01R 31/04* (2006.01)
*H01M 10/42* (2006.01)     *H01M 10/44* (2006.01)
*H02J 7/00* (2006.01)

(86) Numéro de dépôt international:
**PCT/EP2013/063975**

(87) Numéro de publication internationale:
**WO 2014/009211 (16.01.2014 Gazette 2014/03)**

(54) **PROCÉDÉ DE CHARGE D'UNE BATTERIE ET BATTERIE AINSI CHARGÉE**

VERFAHREN ZUR LADUNG EINER BATTERIE UND ENTSPRECHENDE BATTERIE

METHOD OF CHARGING A BATTERY AND CORRESPONDING BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.07.2012 FR 1256625**

(43) Date de publication de la demande:
**20.05.2015 Bulletin 2015/21**

(73) Titulaire: **Blue Solutions**
**29500 Ergué Gabéric (FR)**

(72) Inventeurs:
• **JESTIN, Jean-Jacques**
  **F-29170 Fouesnant (FR)**
• **HINGANT, Dominique**
  **F-29140 Saint-Yvi (FR)**

(74) Mandataire: **Regimbeau**
**Parc d'affaires Cap Nord A**
**2, allée Marie Berhaut**
**CS 71104**
**35011 Rennes Cedex (FR)**

(56) Documents cités:
**WO-A1-2008/009502     US-A1- 2011 012 566**

**Description**

L'invention concerne les batteries électriques et un procédé de charge de celles-ci.

Un domaine d'application de l'invention est les batteries de puissance, telles que par exemple celles servant de source d'énergie pour entraîner une chaîne de traction dans les véhicules électriques. Ce type de batterie à bord d'un véhicule électrique possède par exemple des cellules de technologie lithium - métal - polymère.

Bien entendu, la batterie peut avoir d'autres applications, par exemple pour alimenter des appareils fixes et peut comprendre des cellules présentant une autre technologie, par exemple la technologie lithium-ion.

Ces batteries sont généralement constituées d'une pluralité de cellules élémentaires connectées en série, qui peuvent être chargées en connectant celles-ci à un chargeur adapté.

Chacune des cellules a ses propriétés intrinsèques, qui peuvent différer des propriétés des autres cellules.

Le chargement de la batterie est toutefois effectué à l'aide d'une unique source d'énergie constituée par le chargeur.

D'une manière générale dans les procédés connus, on continue de charger certaines cellules déjà totalement chargées tant que toutes les cellules n'ont pas encore atteint leur niveau de charge maximal.

Or, lors de la charge de la batterie, continuer d'approvisionner en énergie des cellules ayant déjà atteint leur niveau de charge maximal peut dégrader leurs propriétés et notamment accélérer leur vieillissement.

Le document US2002/0094623 décrit un procédé de charge d'une batterie comportant une pluralité de cellules rechargeables, des bornes de charge des cellules, apte à être connectées à un chargeur, un circuit de contournement associé à chaque cellule, des éléments de commutation permettant de connecter et de déconnecter chaque cellule à son circuit de contournement associé et des moyens de commande des éléments de commutation,
procédé dans lequel pour la charge des cellules de la batterie on connecte les bornes de charge des cellules à un chargeur et on connecte par les éléments de commutation chaque cellule à son circuit de contournement associé pendant une durée prédéterminée.

Plus précisément, le procédé de charge selon ce document US2002/0094623 prévoit successivement une étape de charge de chaque cellule jusqu'à atteindre une tension donnée d'initialisation, une étape d'initialisation avec contournement de la cellule par un circuit pendant la durée prédéterminée, une étape de charge normale jusqu'à atteindre une tension de charge complète, et une étape de relaxation par charge à tension constante.

Un des inconvénients de ce procédé connu est que chaque cellule continue d'évoluer différemment des autres cellules.

Un autre inconvénient de ce dernier est qu'un courant non négligeable passe lors de l'étape d'initialisation avec contournement.

Un autre inconvénient est que l'étape d'initialisation avec contournement s'effectue une fois la charge largement commencée atteignant une tension d'initialisation de 2.2 V (pour une tension de charge complète de 3 V).

Le document WO-A-2008/009502 décrit une baterrie ainsi qu'un procédé de charge d'une batterie selon l'etat de la technique.

L'invention vise à obtenir une batterie et un procédé de charge d'une batterie, qui pallie les inconvénients de l'état de la technique et permette de piloter les différentes cellules lors de la charge de la batterie.

A cet effet, un premier objet de l'invention est un procédé de charge d'une batterie, la batterie comportant une pluralité de cellules rechargeables, des bornes de charge des cellules, aptes à être connectées à un chargeur, un circuit de contournement associé à chaque cellule, des éléments de commutation permettant de connecter et de déconnecter chaque cellule à son circuit de contournement associé et des moyens de commande des éléments de commutation,
caractérisé en ce que pour effectuer la i-ème charge de la batterie, avec i supérieur ou égal à deux,
on détecte la connexion des bornes de charge au chargeur, la connexion des bornes de charge au chargeur ayant été détectée déclenchant, lors d'une première phase, la connexion de cellules à leur circuit de contournement associé respectivement pendant une première durée de contournement préemptif, associée respectivement à la cellule,

-    puis, pour chaque cellule, une fois la première durée écoulée, on déconnecte, lors d'une deuxième phase associée, le circuit de contournement associé de la cellule jusqu'à ce que la tension de la cellule atteigne une tension prédéterminée, qui est prescrite pour la cellule et qui est non nulle,
     la première durée de contournement préemptif, associée respectivement à la cellule pour la i-ème charge, ayant été calculée en fonction de la durée totale de connexion, lors d'au moins une charge précédente, du circuit de contournement associé à cette cellule jusqu'à ce que toutes les cellules aient atteint la tension prédéterminée,
     au moins une durée associée à la cellule permettant de déterminer :

     -    la première durée de contournement préemptif pour la i-ème charge, et/ou
     -    ladite durée totale de connexion du circuit de contournement associé à cette cellule lors de cette au moins une charge précédente,

ayant été mémorisée dans une mémoire de la batterie lors de cette au moins une charge précédente.

On notera que la première phase peut être de durée nulle pour au moins une cellule. En outre, la ou les durées mémorisées peuvent par exemple comprendre la première durée de contournement préemptif ou la durée totale de connexion du circuit de contournement à cette cellule.

Suivant un mode de réalisation de l'invention, pour au moins l'une des cellules, à la fin de la deuxième phase, le circuit de contournement associé est connecté à la cellule pour que la tension de la cellule ne dépasse pas une tension de seuil de charge pendant une troisième phase associée de maintien de charge au moins jusqu'à ce que les tensions des cellules aient toutes atteint la tension prédéterminée.

Suivant un mode de réalisation de l'invention, l'on mesure une troisième durée ($M_{ji}$) de connexion du circuit de contournement associé à la cellule lors de la troisième phase, la première durée prédéterminée de contournement préemptif associée à la cellule pour la i-ème charge tenant compte au moins de la première durée de connexion du circuit de contournement associé à la cellule lors de la première phase d'au moins une charge précédente et de la troisième durée de connexion du circuit de contournement associé à la cellule lors de la troisième phase de ladite au moins une charge précédente.

Suivant un mode de réalisation de l'invention, chaque cellule est associée à un élément de mesure de la tension de la cellule et à un compteur de la troisième durée de contournement de la troisième phase de contournement, l'élément de mesure étant apte à comparer la tension de la cellule mesurée à la tension prédéterminée et à déclencher le comptage par le compteur de la troisième durée de contournement lorsque la tension de la cellule a atteint la tension prédéterminée.

Suivant un mode de réalisation de l'invention, les compteurs sont commandés pour compter comme fin de la troisième durée de contournement le moment à partir duquel toutes les cellules ont atteint la tension prédéterminée.

Suivant un mode de réalisation de l'invention, la première durée de contournement préemptif, associée respectivement à la cellule pour la i-ème charge, est calculée en fonction de la durée totale de connexion, lors de la i-1 ème charge, du circuit de contournement associé à cette cellule jusqu'à ce que toutes les cellules aient atteint la tension prédéterminée.

Suivant un mode de réalisation de l'invention, ladite au moins une durée associée à la cellule permettant de déterminer :

- la première durée de contournement préemptif pour la i-ème charge, et/ou
- ladite durée totale de connexion du circuit de contournement associé à cette cellule lors de la i-1 ème charge,

a été mémorisée dans une mémoire (21) de la batterie lors de la i-1 ème charge.

Suivant un mode de réalisation de l'invention, l'on mémorise lors de ladite au moins une charge précédente, comme durée associée à la cellule, au moins la première durée de contournement préemptif, associée respectivement à la cellule pour la i-ème charge. La première durée de contournement préemptif pour la i-ème charge a par exemple été mémorisée dans une mémoire de la batterie lors de la i-1 ème charge. Cette durée a alors été calculée lors de la i-1ème charge.

D'autres paramètres peuvent avoir été mémorisés lors de cette charge tels que la durée totale de connexion de contournement de la i-1 ème charge ou des durées permettant de déterminer cette durée totale (par exemple la durée totale de charge de la batterie associée à la durée de la deuxième phase pour chaque cellule (j)).

Suivant un mode de réalisation de l'invention, l'on mémorise lors de ladite au moins une charge précédente, comme durée associée à la cellule, au moins ladite durée totale de connexion du circuit de contournement associé à cette cellule lors de cette au moins une charge précédente.

Suivant un mode de réalisation de l'invention, la première durée $TP_{ji}$ de contournement préemptif, associée respectivement à la cellule j pour la i-ème charge, est calculée de la manière suivante :

$$TP_{ji} = TP_{ji-1} + M_{ji-1} - \min_j(TP_{ji-1} + M_{ji-1})$$

où $\min_j (TP_{ji-1} + M_{ji-1})$ désigne le minimum de $TP_{ji-1} + M_{ji-1}$ sur les cellules j.

Suivant un mode de réalisation de l'invention, la première durée $TP_{ji}$ de contournement préemptif, associée respectivement à la cellule j pour la i-ème charge, est calculée de la manière suivante :

$$TP_{ji} = a.(TP_{ji-1} + M_{ji-1}) - b.\min_j(TP_{ji-1} + M_{ji-1})$$

où $\min_j (TP_{ji-1} + M_{ji-1})$ désigne le minimum de $TP_{ji-1} + M_{ji-1}$ sur les cellules j, et où a, b sont des coefficients prescrits non nuls.

Suivant un mode de réalisation de l'invention, les coefficients a et b sont déterminés en fonction du niveau de charge de la batterie lorsque la connexion de celle-ci au chargeur est détectée.

Dans un mode de réalisation, a et b sont relatifs au niveau de charge de la batterie lorsque la connexion de celle-ci au chargeur est détectée. Ces coefficients peuvent notamment être proportionnels à (1-NCR) où NCR est le niveau de charge restant de la batterie. Les coefficients a et b peuvent également être égaux.

Suivant un mode de réalisation de l'invention, pour la première charge de chaque cellule de la batterie, on détecte la connexion des bornes de charge au chargeur, la connexion des bornes de charge au chargeur ayant été détectée déclenchant pendant une deuxième phase associée la déconnexion de chaque cellule par rapport à son circuit de contournement associé pour charger la cellule jusqu'à ce que la tension respective de la cellule atteigne la tension prédéterminée,

puis pour au moins l'une des cellules, à la fin de la deuxième phase associée, le circuit de contournement associé est connecté à la cellule pour que la tension de la cellule ne dépasse pas la tension de seuil de charge pendant une troisième phase associée de maintien de charge jusqu'à ce que les tensions des cellules aient toutes atteint la tension prédéterminée,

la première durée de contournement préemptif associée respectivement à la cellule et valable pour au moins la deuxième charge correspondant à la troisième durée de connexion du circuit de contournement associé à la cellule lors de la troisième phase de la première charge.

Suivant un mode de réalisation de l'invention, ladite tension prédéterminée est une tension inférieure ou égale à la tension de seuil dé charge qui est prescrite pour la cellule et qui est non nulle.

Suivant un mode de réalisation de l'invention, les cellules sont réalisées par assemblage de films.

Suivant un mode de réalisation de l'invention, les cellules ont une température nominale de fonctionnement supérieure à 20 °C.

Un autre objet de l'invention est une batterie comportant une pluralité de cellules rechargeables, des bornes de charge des cellules, aptes à être connectées à un chargeur, un circuit de contournement associé à chaque cellule, des éléments de commutation permettant de connecter et de déconnecter chaque cellule à son circuit de contournement associé et des moyens de commande des éléments de commutation, des moyens de mesure de la tension de chaque cellule,

caractérisé en ce que les moyens de commande comportent des moyens de calcul d'une première durée de contournement préemptif, associée respectivement à la cellule pour la i-ème charge avec i ≥ 2 en fonction de la durée totale de connexion, lors d'au moins une charge précédente, du circuit de contournement associé à cette cellule jusqu'à ce que toutes les cellules aient atteint une tension prédéterminée,

la batterie comportant au moins une mémoire pour mémoriser au moins une durée associé à la cellule et permettant de déterminer :

- la première durée de contournement préemptif pour la i-ème charge, et/ou
- ladite durée totale de connexion du circuit de contournement à cette cellule lors de cette au moins une charge précédente,

la batterie comprenant un détecteur de la connexion des bornes de charge au chargeur,

les moyens de commande étant prévus pour déclencher pour la i-ème charge de la batterie, la connexion de la pluralité des cellules à leur circuit de contournement associé en réponse au fait que le détecteur a détecté que les bornes de charge sont connectées au chargeur, et pour maintenir la connexion de chaque cellule à son circuit de contournement associé pendant la première durée de contournement préemptif, associée respectivement à la cellule pour la i-ème charge de la batterie,

les moyens de commande étant prévus pour déconnecter à la fin de la première durée de contournement préemptif le circuit de contournement associé de chaque cellule pendant une deuxième phase associée pour la i-ème charge de la batterie jusqu'à ce que la tension de la cellule atteigne la tension prédéterminée, qui est prescrite pour la cellule (j) et qui est non nulle.

L'invention sera mieux comprise à la lecture de la description qui va suivre, donnée uniquement à titre d'exemple non limitatif en référence aux dessins annexés, sur lesquels :

- la figure 1 représente schématiquement un mode de réalisation d'une batterie suivant l'invention,
- la figure 2 représente schématiquement un exemple d'organigramme du procédé de charge suivant l'invention,
- la figure 3 représente schématiquement un chronogramme des différentes phases de fonctionnement des différentes cellules de la batterie au cours du procédé de charge suivant l'invention lors d'une première charge de la batterie,
- la figure 4 représente schématiquement un chronogramme des différentes phases de fonctionnement des différentes cellules de la batterie au cours du procédé de charge suivant l'invention pour la deuxième charge de la batterie,
- la figure 5 représente schématiquement un chronogramme des différentes phases de fonctionnement des différentes cellules de la batterie au cours du procédé de charge suivant l'invention pour la i-1 ème charge de la batterie,
- la figure 6 représente schématiquement un chronogramme des différentes phases de fonctionnement des différentes cellules de la batterie au cours du procédé de charge suivant l'invention pour la i-ème charge de la batterie,
- la figure 7 représente schématiquement des courbes de la tension de différentes cellules de la batterie en ordonnée en fonction du temps en abscisse lors de la première charge,
- la figure 8 représente schématiquement des courbes des tensions de cellules de la batterie en ordonnée en fonction du temps en abscisse lors d'une i-ème charge.

Aux figures, la batterie électrique 10 comporte N cellules 1, ..., j,...N désignées globalement par cellules j, avec N supérieur ou égal à 2.
Dans ce qui suit, il est par exemple prévu des cellules j, k, 1, m, p, q, r, avec

$$1 \leq j \leq N,$$

$$1 \leq k \leq N,$$

$$1 \leq l \leq N,$$

$$1 \leq m \leq N,$$

$$1 \leq p \leq N,$$

$$1 \leq q \leq N,$$

$$1 \leq r \leq N.$$

L'invention est décrite ci-dessous en référence au mode de réalisation représenté aux figures, dans lequel les cellules j sont réalisées par exemple par assemblage de films, par exemple en lithium - métal - polymère. L'épaisseur totale de ces films est par exemple inférieure à 300 micromètres et par exemple de 150 micromètres environ. Les cellules ont une température nominale de fonctionnement supérieure à 20 °C, par exemple de 90 °C pour une technologie lithium - métal - polymère.
Dans la description qui suit, les cellules j sont en série. Les cellules sont par exemple en série, et sont chacune rechargeables et déchargeables. Les cellules sont par exemple identiques.
La batterie 10 comporte une unité 20 de contrôle de ses propres cellules j.
La batterie 10 comporte des bornes 11, 12 de charge des cellules j. Les bornes 11, 12 de charges sont distinctes l'une de l'autre. Il est par exemple prévu au moins une première borne 11 de charge des cellules j et une deuxième borne 12 de charge des cellules j. L'ensemble des cellules j est par exemple connecté entre les bornes 11, 12 de charge. Les cellules j sont par exemple connectées en série entre les bornes 11, 12 de charge. Les bornes 11, 12 de charge sont aptes à être connectées à un chargeur 100, tel que par exemple un chargeur extérieur 100. Le chargeur 100 comporte des bornes 101, 102 de connexion respectivement aux bornes 11, 12 de charge, et un organe 103 de chargement connecté entre les bornes 101 et 102 pour envoyer à celles-ci un courant de chargement des cellules j, lorsque les bornes 101 et 102 sont connectées aux bornes 11 et 12 de la batterie 10. Le fait qu'une cellule soit complètement chargée correspond au fait que la tension entre ses bornes individuelles de cellule soit égale en valeur absolue à une tension prescrite de seuil de charge, qui est par exemple une tension maximum en valeur absolue et qui est non nulle. Le fait qu'une cellule ne soit pas complètement chargée, ou soit partiellement ou complètement déchargée, correspond au fait que la tension entre ses bornes individuelles de cellule soit inférieure en valeur absolue à la tension prescrite de seuil de charge ou soit nulle. La tension de seuil de charge est prescrite pour la cellule j et est non nulle. Les bornes individuelles de chaque cellule sont différentes des bornes 11, 12 de charge de la batterie, sauf éventuellement pour une borne individuelle de la première cellule 1 reliée à la borne 11 de charge et pour une borne individuelle de la dernière cellule N reliée à la borne 12 de charge.

La batterie peut comporter par exemple un ou plusieurs éléments de chauffe des cellules j à leur température nominale de fonctionnement, par exemple sous la forme d'une ou plusieurs plaques de chauffe, qui sont alimentées en courant électrique par les bornes 11, 12, notamment pour les cellules réalisées par assemblage de films, par exemple en lithium - métal - polymère.

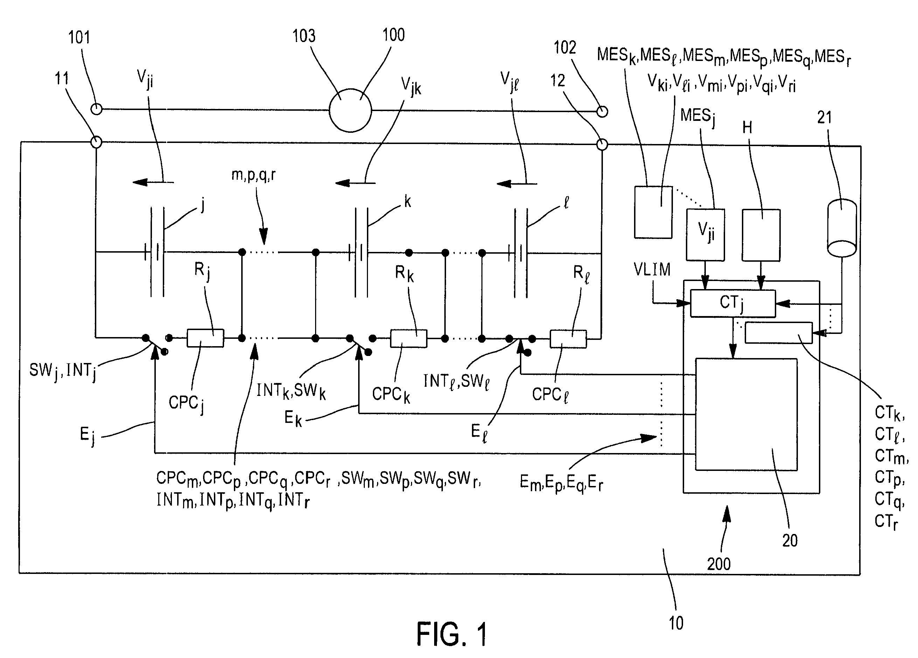

La batterie 10 comporte en outre un circuit $CPC_j$ de contournement associé à chaque cellule j. En outre, la batterie 10 comporte des éléments $SW_j$ de commutation permettant de connecter et de déconnecter chaque cellule j à son circuit $CPC_j$ de contournement associé. Lorsque le circuit $CPC_j$ de contournement est connecté à sa cellule j associée, ce circuit $CPC_j$ de contournement est branché en parallèle avec cette cellule j, ainsi que cela est représenté à titre d'exemple pour la cellule 1 et son circuit de contournement associé $CPC_1$ à la figure 1.

D'une manière générale, chaque circuit $CPC_j$ de contournement associé à sa cellule j est électriquement en parallèle avec sa cellule j associée. Autrement dit, chaque circuit $CPC_j$ de contournement est branché sur les bornes individuelles de la cellule j associée en position de connexion de l'élément $SW_j$ de commutation associé. Ainsi, en position de déconnexion du circuit $CPC_j$ de contournement par l'élément $SW_j$ de commutation associé, le courant de charge envoyé par le chargeur 100 sur les bornes 11, 12 de charge est envoyé à la cellule j pour effectuer son chargement ou son rechargement. En position de connexion du circuit $CPC_j$ de contournement à sa cellule j associée, il existe un contournement partiel ou total du courant de charge envoyé par le chargeur 100 sur les bornes 11, 12 de charge par rapport à la cellule j, c'est-à-dire qu'au moins une partie du courant de charge arrivant aux bornes 11, 12 est déviée dans le circuit $CPC_j$ de contournement. Le circuit $CPC_j$ de contournement comporte par exemple une ou plusieurs résistance électrique $R_j$ pour chaque cellule j.

L'élément $SW_j$ de commutation comporte par exemple un interrupteur $INT_j$, qui est fermé en position de connexion et qui est ouvert en position de déconnexion. L'élément SWj de commutation est par exemple en série avec le circuit $CPC_j$ de contournement associé, ce circuit en série comprenant cet élément $SW_j$ de commutation et ce circuit $CPC_j$ de contournement étant relié en parallèle avec la cellule j associée.

La batterie 10 comporte en outre des moyens 200 de commande des éléments $SW_j$ de commutation, pour commander individuellement leur passage dans la position de connexion et dans la position de déconnexion. Chaque élément $SW_j$ de commutation comporte par exemple une entrée $E_j$ de commande reliée à l'unité 20 faisant partie des moyens 20 de commande. Les moyens 20, 200 de commande sont par exemple formés par une carte électronique, par exemple munie d'un calculateur ou d'au moins un microprocesseur, notamment pour commander les éléments $SW_j$ de commutation.

Les moyens 200 de commande commandent ainsi les éléments $SW_j$ de commutation respectifs afin de mettre en oeuvre les différentes phases des cellules, qui seront décrites ci-dessous.

Suivant l'invention, il est prévu pour chaque charge de la batterie 10 ultérieure à la première charge, c'est-à-dire pour la i-ème charge, avec i supérieur ou égal à 2, une première phase de contournement préemptif ayant une durée $TP_{ji}$ de contournement préemptif pour respectivement la cellule j, cette durée $TP_{ji}$ ayant été calculée en fonction de la durée totale de connexion du circuit de contournement associé $CPC_j$ à cette cellule j lors d'au moins une charge précédente, cette durée totale de connexion du circuit $CPC_j$ de contournement étant la durée nécessaire pour que toutes les cellules j de la batterie 10 aient atteint une tension prédéterminée VLIM lors de cette au moins une charge précédente. Cette première durée $TP_{ji}$ de contournement préemptif pour la i-ème charge a été mémorisée au cours de l'étape MEM dans une mémoire 21 de la batterie 10 lors de cette au moins une charge précédente.

Suivant un mode de réalisation, la tension déterminée VLIM est égale à la tension de seuil de charge.

Suivant un mode de réalisation, la tension déterminée VLIM est une tension inférieure ou égale à la tension de seuil de charge, par exemple égale à une valeur fixe, qui est supérieure ou égale à 90 % de la tension de seuil de charge et qui est inférieure ou égale à 100% de la tension de seuil de charge.

Pour cette i-ème charge, la première phase de contournement préemptif est suivie, pour chaque cellule j, d'une deuxième phase associée $C_j$, où le circuit de contournement associé $CPC_j$ est déconnecté de la cellule j jusqu'à ce que la tension $V_{ji}$ de la cellule j atteigne la tension prédéterminée VLIM. La cellule j se charge est ainsi chargée pendant cette deuxième phase $C_j$ par le chargeur 100 connecté aux bornes 1, 12 ainsi La tension prédéterminée VLIM est prescrite pour la cellule j et est non nulle.

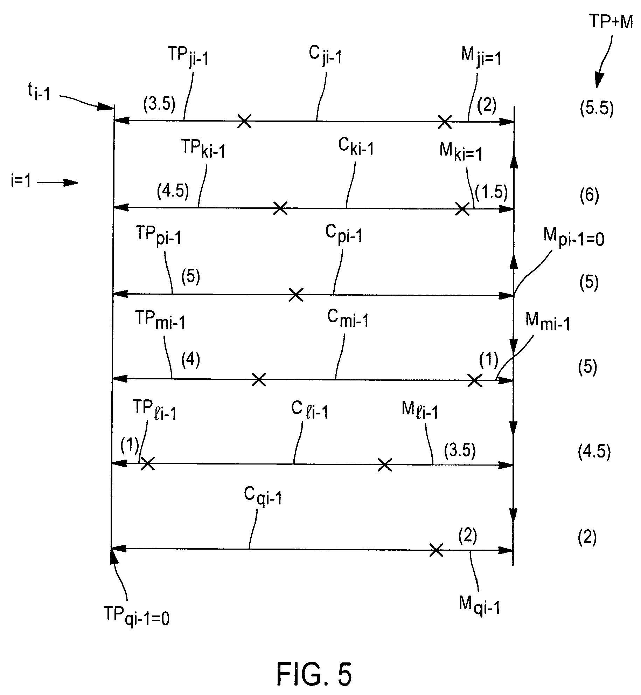

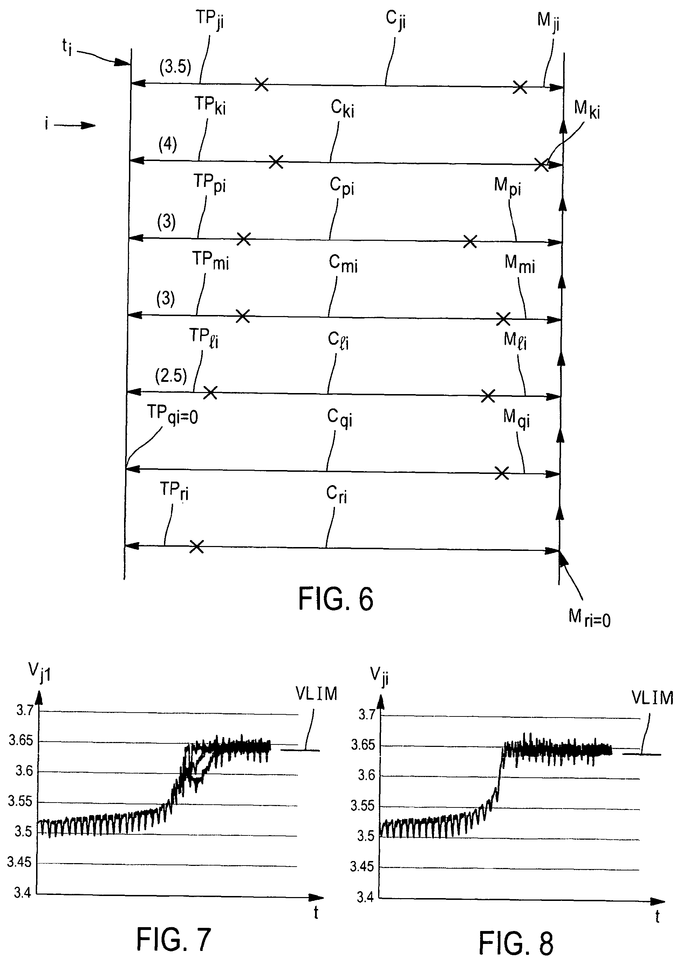

Les différentes phases apparaissant lors de la i-ème charge seront décrites plus en détail ci-dessous en référence aux figures 5 et 6 données à titre d'exemples illustratifs.

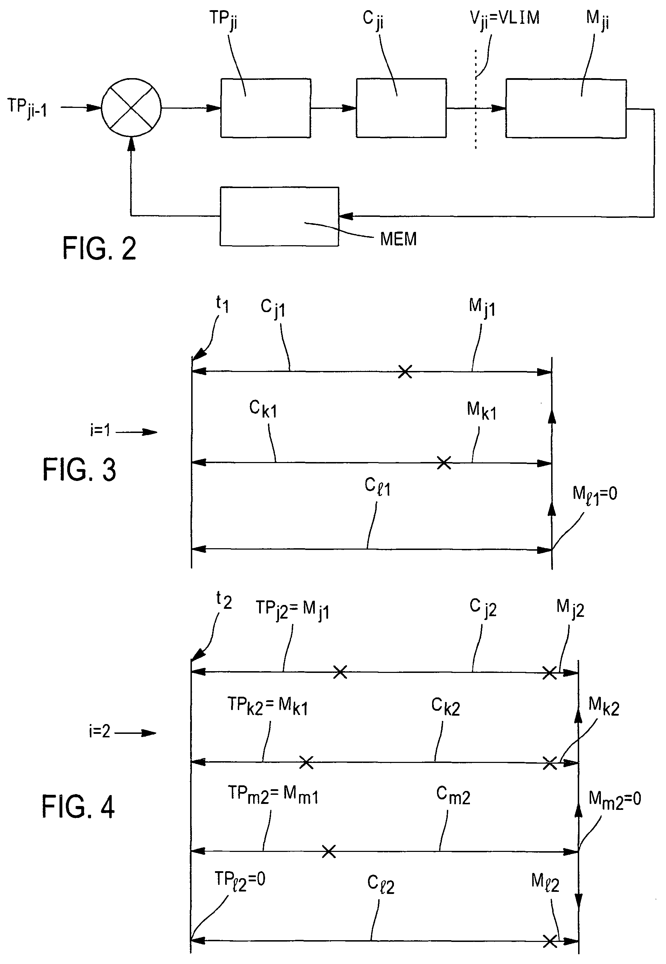

On décrit tout d'abord ci-dessous les étapes apparaissant lors de la première charge de la batterie 10 en référence à la figure 3 donnée à titre d'exemple illustratif.

Le terme "associé" signifie les parties associées à une cellule j et porte le même indice j ou le même autre indice que cette cellule associée.

Première charge i = 1

Lors de la première charge, on détecte, par exemple à l'instant $t_1$, la connexion des bornes 11, 12 de charge au chargeur 100. La connexion des bornes 11, 12 de charge au chargeur 100 ayant été détectée déclenche pendant une deuxième phase associée $C_{j1}$ la déconnexion de chaque cellule j par rapport à son circuit de contournement associé $CPC_j$ pour charger la cellule j jusqu'à ce que la tension respective $V_{j1}$ de la cellule j atteigne la tension prédéterminée VLIM.
Il est par exemple prévu pour chaque cellule j un élément $MES_j$ de mesure de la tension de la cellule j. La tension $V_{ji}$ mesurée par l'élément $MES_j$ de la cellule j est envoyée aux moyens 200 de commande.
Puis, pour au moins l'une des cellules j, à la fin de la deuxième phase associée $C_{j1}$, c'est-à-dire lorsque cette cellule j a atteint la tension prédéterminée VLIM, le circuit de contournement associé $CPC_j$ est connecté à la cellule j pour maintenir la tension $V_{j1}$ de la cellule j à la tension prédéterminée VLIM pendant une troisième phase associée $M_{j1}$ de maintien de charge jusqu'à ce que les tensions $V_{j1}$, $V_{k1}$, $V_{l1}$ de toutes les cellules j, k, 1 (et autres) ne dépassent pas la tension de seuil de charge.
Ainsi qu'on le voit à la figure 3, il est donc prévu pour la cellule j lors de la première charge (i = 1), et ce dès la détection de la connexion de la batterie au chargeur, la mise en oeuvre de la deuxième phase $C_{j1}$ de déconnexion de la cellule j par rapport à son circuit de contournement associé $CPC_j$, puis la troisième phase $M_{j1}$ de maintien de charge de troisième durée $M_{j1}$ de maintien de charge.
Il est donc prévu pour la cellule k lors de la première charge (i = 1), et ce dès la détection de la connexion de la batterie au chargeur, la mise en oeuvre de la deuxième phase $C_{k1}$ de déconnexion de la cellule k par rapport à son circuit de contournement associé $CPC_k$, puis la troisième phase $M_{k1}$ de maintien de charge de de troisième durée $M_{k1}$ de maintien de charge.
Il est prévu pour la cellule 1 lors de la première charge (i = 1), et ce dès la détection de la connexion de la batterie au chargeur, la mise en oeuvre de la deuxième phase $C_{l1}$ de déconnexion de la cellule 1 par rapport à son circuit de contournement associé $CPC_1$ pour charger la cellule 1 jusqu'à ce que la tension respective $V_{l1}$ de la cellule 1 atteigne la tension prédéterminée VLIM. Puis, la troisième phase associée $M_{l1}$ de maintien de charge de durée nulle, étant donné que la cellule 1 est par exemple la cellule mettant le plus de temps à être chargée et mettant donc le plus de temps à ce que sa tension $V_{l1}$ de cellule 1 atteigne la tension prédéterminée VLIM. Par conséquent, cela revient à dire que la cellule 1 n'a pas de troisième phase associée $M_{l1}$ de maintien de charge ou a une troisième phase associée $M_{l1}$ de maintien de charge de troisième durée $M_{l1}$ de maintien de charge nulle. Ainsi qu'on le voit à la figure 3, la fin de la deuxième phase $C_{l1}$ de la cellule 1, qui est la plus longue pour toutes les cellules, provoque la fin des troisièmes phases $M_{j1}$, $M_{k1}$ de maintien de charge des autres cellules j, k.
On mémorise lors de cette première charge i = 1 lors de l'étape MEM dans la mémoire 21 de la batterie 10 comme première durée $TP_{j2}$ de contournement préemptif associée respectivement à la cellule j, la troisième durée $M_{j1}$ de connexion du circuit de contournement associé $CPC_j$ à la cellule j lors de la troisième phase $M_{j1}$ de la première charge, soit $TP_{j2} = M_{j1}$.
De même, pour les autres cellules, par exemple pour la cellule k, on mémorise lors de cette première charge i = 1 dans la mémoire 21 de la batterie 10 comme première durée $TP_{k2}$ de contournement préemptif associé respectivement à la cellule k, la troisième durée $M_{k1}$ de connexion du circuit de contournement associé $CPC_k$ à la cellule k lors de la troisième phase $M_{k1}$ de la première charge, soit $TP_{k2} = M_{k1}$.
Pour la cellule 1, la durée $TP_{12}$ mémorisée est nulle.

Deuxième charge i = 2

Lors de la deuxième charge i = 2, on détecte, par exemple à l'instant $t_2$, la connexion des bornes 11, 12 de charge au chargeur 100, ainsi que cela est représenté à titre illustratif à la figure 4.
La connexion des bornes 11, 12 de charge au chargeur 100 ayant été détectée déclenche la connexion de cellules j, k, m à leur circuit de contournement associé $CPC_j$, $CPC_k$, $CPC_m$ respectivement pendant une première durée de contournement préemptif $TP_{j2} = M_{j1}$, $TP_{k2} = M_{k1}$, $TP_{m2} = M_{m1}$, associé à la cellule j, k, m. Ces premières durées $TP_{j2}$, $TP_{k2}$, $TP_{m2}$ de contournement préemptif, associées respectivement aux cellules j, k, m pour la deuxième charge, ont été calculées en fonction de la durée totale de connexion des circuits de contournement associés $CPC_j$, $CPC_k$, $CPC_m$ à ces cellules j, k, m, laquelle durée totale de connexion a été déterminée lors de la première charge (i = 1) précédente et est la durée nécessaire pour que toutes les cellules j, k, m aient atteint la tension prédéterminée VLIM. Cette première durée $TP_{j2}$, $TP_{k2}$, $TP_{m2}$ de contournement préemptif pour la deuxième charge a été mémorisée dans la mémoire 21 de la batterie 10 lors de cette première charge précédente au cours de l'étape MEM. Il en est ainsi pour toutes les cellules, sauf pour la au moins une cellule 1, pour laquelle la première durée de contournement préemptif $TP_{12} = 0$ et pour laquelle la deuxième phase $C_{l2}$ est tout de suite effectuée après l'instant initial $t_2$ de commencement de la deuxième charge i = 2.
Ensuite, pour chaque cellule j, k, m, l, c'est-à-dire pour toutes les cellules, est effectuée la deuxième phase

associée $C_{j2}$, $C_{k2}$, $C_{m2}$, $C_{l2}$, où le circuit des contournements associés $CPC_j$, $CPC_k$, $CPC_m$, $CPC_l$ est déconnecté de la cellule j, k, m, 1 jusqu'à ce que la tension $V_{j2}$, $V_{k2}$, $V_{m2}$, $V_{l2}$ de la cellule j, k, m, 1 atteigne la tension prédéterminée VLIM. Pendant cette deuxième phase $C_{j2}$, $C_{k2}$, $C_{m2}$, $C_{l2}$, la cellule correspondante j, k, m, 1 est rechargée jusqu'à la tension prédéterminée VLIM par le courant de charge, qui est envoyé sur aux bornes 11, 12 par le chargeur 100.

Il se peut ainsi que toutes les deuxièmes phases associées $C_{j2}$, $C_{k2}$, $C_{m2}$, $C_{12}$ finissent exactement en même temps. Il s'agit d'un cas idéal. Dans ce cas, il n'est pas nécessaire d'effectuer la troisième phase de maintien de charge après la deuxième phase pour les cellules. Toutefois, en pratique, les deuxièmes phases $C_{j2}$, $C_{k2}$, $C_{m2}$, $C_{l2}$ peuvent ne pas se terminer en même temps, c'est-à-dire qu'il peut y avoir la deuxième phase $C_{m2}$ qui se finit la dernière pour la cellule m par rapport aux autres cellules. Dans ce cas, on prévoit pour toutes les cellules autres que la ou les cellules m dont la deuxième phase associée $C_{m2}$ se termine la dernière, une troisième phase de maintien de charge $M_{j2}$, $M_{k2}$, $M_{l2}$, respectivement pour les cellules j, k, 1. Ceci équivaut au fait de faire suivre la deuxième phase $C_{m2}$ de la cellule m par une troisième phase associée $M_{m2} = 0$, c'est-à-dire de troisième durée $M_{m2}$ nulle de maintien de charge.

Les moyens 20 de commande font partie d'une unité 200 de contrôle de la batterie 10. Cette unité 200 de contrôle de la batterie 10 comporte, en plus des éléments $MES_j$ de mesure de la tension $V_{ji}$ des cellules j, une horloge H et un compteur $CT_j$ associé respectivement à chaque cellule j.

Suivant un mode de réalisation, chaque cellule j est associée à un élément $MES_j$ de mesure de la tension $V_{ji}$ de la cellule j et à un compteur $CT_j$ de la troisième durée $M_{ji}$ de contournement de la troisième phase $M_{ji}$ de contournement, l'élément de mesure $MES_j$ étant apte à comparer la tension $V_{ji}$ de la cellule j mesurée à la tension prédéterminée VLIM et à déclencher le compteur $CT_j$ de sorte qu'il compte comme troisième durée $M_{ji}$ de contournement le temps à partir duquel la tension $V_{ji}$ de la cellule j a atteint la tension prédéterminée VLIM. Chaque compteur compte le temps écoulé depuis l'instant où il a été déclenché par le signal reçu depuis l'élément de mesure, à savoir lorsque la tension $V_{ji}$ de la cellule j a atteint la tension prédéterminée VLIM. La dernière cellule m atteignant cette tension prédéterminée VLIM lors de la deuxième phase $C_{m2}$ déclenche l'arrêt des compteurs $CT_j$, $CT_k$, $CT_l$ des autres cellules j, k, l, lesquels compteurs fournissent alors les troisièmes durées $M_{j2}$, $M_{k2}$, $M_{l2}$ de maintien de charge ainsi comptées, qui sont alors mémorisées dans la mémoire 21 au cours de l'étape MEM.

De même, il est prévu, en association respectivement avec les cellules k, 1, m, p, q, r, les organes $MES_k$, $MES_l$, $MES_m$, $MES_p$, $MES_q$, $MES_r$ de mesure de leurs tensions respectives $V_{ki}$, $V_{li}$, $V_{mi}$, $V_{pi}$, $V_{qi}$, $V_{ri}$, des compteurs respectifs $CT_k$, $CT_l$, $CT_m$, $CT_p$, $CT_q$, $CT_r$ du temps écoulé depuis le passage de la cellule associée respective k, l, m, p, q, r à la tension prédéterminée VLIM, ainsi que les circuits de contournement associés $CPC_k$, $CPC_l$, $CPC_m$, $CPC_p$, $CPC_q$, $CPC_r$, les éléments de commutation associés $SW_k$, $SW_l$, $SW_m$, $SW_p$, $SW_q$, $SW_r$, les interrupteurs associés $INT_k$, $INT_l$, $INT_m$, $INT_p$, $INT_q$, $INT_r$, les entrées de commande associées $E_k$, $E_l$, $E_m$, $E_p$, $E_q$, $E_r$.

Charge i-1 (i $\geq$ 2)

A la figure 5, pour la i-1 -ème charge, pour la cellule j, on détecte la connexion des bornes 11, 12 de charge au chargeur 100 à l'instant $t_{i-1}$. Cette connexion des bornes de charge au chargeur 100 ayant été détectée déclenche la connexion de la cellule j à son circuit de contournement associé $CPC_j$ pendant la première durée $TP_{ji-1}$ de contournement préemptif associé à la cellule j. Puis, pendant la deuxième phase $C_{ji-1}$ associée à la cellule j, le circuit de contournement associé $CPC_j$ a été déconnecté de cette cellule j jusqu'à ce que la tension $V_{ji-1}$ de la cellule j atteigne la tension prédéterminée VLIM pour charger la cellule j. Puis, à la fin de la deuxième phase $C_{ji-1}$, le circuit de contournement $CPC_j$ est connecté à la cellule j associée pour que la tension $V_{ji-1}$ de la cellule j ne dépasse pas la tension de seuil de charge pendant la troisième phase $M_{ji-1}$ associée de maintien de charge au moins jusqu'à ce que les tensions de toutes les cellules aient atteint la tension prédéterminée VLIM.

De même, il est prévu, respectivement pour les cellules k, m et 1, la première durée $TP_{ki-1}$, $TP_{mi-1}$, $TP_{li-1}$ de contournement préemptif, puis la deuxième phase associée $C_{ki-1}$, $C_{mi-1}$, $C_{li-1}$ pour charger la cellule k, m, 1 jusqu'à la tension prédéterminée VLIM et ensuite la troisième phase de maintien de charge ayant la troisième durée $M_{ki-1}$, $M_{mi-1}$), $M_{li-1}$ de connexion du circuit de contournement associé $CPC_k$, $CPC_m$, $CPC_l$ à la cellule respective k, m, 1.

On suppose que lors de la charge i-1, la cellule q a une première durée $TP_{qi-1} = 0$, du fait qu'elle a été la dernière à avoir atteint la tension prédéterminée VLIM précédemment et que donc la connexion des bornes 11, 12 de charge au chargeur 100 déclenche pour la cellule q à l'instant $t_{i-1}$ initial la deuxième phase $C_{qi-1}$ associée, où le circuit de contournement associé $CPC_q$ est déconnecté de la cellule q pour charger cette cellule q jusqu'à ce que la tension $V_{qi-1}$ de la cellule q atteigne la tension prédéterminée VLIM. Puis, à la fin de cette deuxième phase $C_{qi-1}$, le circuit du contournement associé $CPC_q$ est connecté à la cellule q pour maintenir la tension $V_{qi-1}$ de la cellule q à la tension prédéterminée VLIM pendant la troisième phase $M_{qi-1}$ associée de maintien de charge. Bien entendu, la cellule q peut être différente des cellules j, k, m et 1 ou être l'une de ces cellules j, k, m, 1.

De même, la cellule p possède la première durée $TP_{pi-1}$ de contournement préemptif, mais on suppose que c'est cette cellule p qui atteint la dernière la tension prédéterminée VLIM pour charger cette cellule p lors de la deuxième phase associée $C_{pi-1}$, où le circuit de contournement associé CPCp est déconnecté de la cellule p jusqu'à ce que la

tension $V_{pi-1}$ de la cellule p atteigne la tension prédéterminée VLIM. Par conséquent, pour cette cellule p, il n'y a pas de troisième phase de maintien de charge $M_{pi-1}$ ou il y a une troisième phase de maintien de charge ayant une troisième durée nulle $M_{pi-1}$ de maintien de charge de durée, ainsi que représenté à la figure 5. Ceci arrête la troisième phase de maintien de charge $M_{ji-1}$, $M_{ki-1}$, $M_{li-1}$, $M_{mi-1}$, $M_{qi-1}$, des autres cellules j, k, l, m, q. Le chargeur 100 peut alors être déconnecté des bornes 11, 12 de charge. Bien entendu, une troisième phase de maintien de charge $M_{pi-1}$ ayant une troisième durée de maintien de charge $M_{pi-1}$ non nulle pourrait être prévue, ce qui prolongerait d'autant les troisièmes phases de maintien de charge des autres cellules.

Dans un mode de réalisation, il est par exemple prévu une limite de durée de chaque troisième phase de maintien de charge, afin d'automatiquement arrêter la troisième phase de maintien de charge au-delà de cette limite.

Dans un mode de réalisation, le fait que la tension $V_{ji-1}$, $V_{ki-1}$, $V_{li-1}$, $V_{mi-1}$, $V_{pi-1}$, $V_{qi-1}$, $V_{ri-1}$ de la cellule j, k, l, m, p, q, r atteint la tension prédéterminée VLIM est détecté par le l'organe de mesure de tension associé $MES_j$, $MES_k$, $MES_1$, $MES_m$, $MES_p$, $MES_q$, $MES_r$, qui compare la tension mesurée à cette tension prédéterminée VLIM.

Suivant un mode de réalisation, on mesure la troisième durée $M_{ji-1}$, $M_{ki-1}$, $M_{li-1}$, $M_{mi-1}$, $M_{pi-1}$, $M_{qi-1}$, $M_{ri-1}$ de connexion du circuit de contournement $CPC_j$, $CPC_k$, $CPC_l$, $CPC_m$, $CPC_p$, $CPC_q$, $CPC_r$ associé à la cellule j, k, l, m, p, q, r lors de la troisième phase $M_{ji-1}$, $M_{ki-1}$, $M_{li-1}$, $M_{mi-1}$, $M_{pi-1}$, $M_{qi-1}$, $M_{ri-i}$ de maintien de charge, par exemple à l'aide du compteur $CT_j$, $CT_k$, $CT_l$, $CT_m$, $CT_p$, $CT_q$, $CT_r$ et de l'horloge H.

Charge i (i $\geq$ 2)

Lors de la charge i, on détecte, par exemple à l'instant $t_i$, la connexion des bornes 11, 12 de charge au chargeur 100, ainsi que cela est représenté à titre illustratif à la figure 6.

La connexion des bornes 11, 12 de charge au chargeur 100 ayant été détectée déclenche la connexion de cellules j, k, l, m, p, r à leur circuit de contournement associé $CPC_j$, $CPC_k$, $CPC_l$, $CPC_m$, $CPC_p$, $CPC_r$ respectivement pendant une première durée de contournement préemptif $TP_{ji}$, $TP_{ki}$, $TP_{li}$, $TP_{mi}$, $TP_{pi}$, $TP_{ri}$ associée à la cellule j, k, l, m, p, r. Ces premières durées $TP_{ji}$, $TP_{ki}$, $TP_{li}$, $TP_{mi}$, $TP_{pi}$, $TP_{ri}$ de contournement préemptif, associées respectivement aux cellules j, k, 1, m, p, r pour la charge i, ont été calculées en fonction de la durée totale de connexion des circuits de contournement associés $CPC_j$, $CPC_k$, $CPC_l$, $CPC_m$, $CPC_p$, $CPC_r$ à ces cellules j, k, l, m, p, r, laquelle durée totale de connexion a été déterminée lors d'au moins une charge précédente, par exemple la charge précédente i-1, et est la durée nécessaire pour que toutes les cellules j, k, l, m, p, r aient atteint la tension prédéterminée VLIM lors de cette au moins une charge précédente, par exemple la charge précédente i-1. Cette première durée $TP_{ji}$, $TP_{ki}$, $TP_{li}$, $TP_{mi}$, $TP_{pi}$, $TP_{ri}$ de contournement préemptif pour la charge i a été mémorisée dans la mémoire 21 de la batterie 10 au cours de l'étape MEM lors de cette au moins une charge précédente, par exemple la charge précédente i-1. Il en est ainsi pour toutes les cellules, sauf pour la au moins une cellule q, pour laquelle la première durée de contournement préemptif $TP_{qi} = 0$ et pour laquelle la deuxième phase $C_{qi}$ est tout de suite effectuée après l'instant initial $t_i$ de commencement de la charge i pour charger cette cellule q jusqu'à la tension prédéterminée VLIM. Dans un autre mode de réalisation, la durée totale de connexion du circuit de contournement $CPC_j$, $CPC_k$, $CPC_l$, $CPC_m$, $CPC_p$, $CPC_r$ à la cellule j, k, l, m, p, r associée lors de cette au moins une charge précédente, par exemple la charge i-1, permettant de calculer la première durée de contournement pour la charge i, a été mémorisée dans la mémoire 21 de la batterie. Dans un autre mode de réalisation, la première durée $TP_{ji}$, $TP_{ki}$, $TP_{li}$, $TP_{mi}$, $TP_{pi}$, $TP_{ri}$ de contournement préemptif pour la i-ème charge et/ou ladite durée totale de connexion du circuit de contournement $CPC_j$, $CPC_k$, $CPC_l$, $CPC_m$, $CPC_p$, $CPC_r$ à la cellule j, k, l, m, p, r associée lors de cette au moins une charge précédente, par exemple la charge i-1, permettant de calculer la première durée de contournement pour la charge i, a été mémorisée dans la mémoire 21 de la batterie lors de cette au moins une charge précédente, par exemple la charge i-1.

Ensuite, pour chaque cellule j, k, l, m, p, q, r, c'est-à-dire pour toutes les cellules, est effectuée la deuxième phase associée $C_{ji}$, $C_{ki}$, $C_{li}$, $C_{mi}$, $C_{pi}$, $C_{qi}$, $C_{ri}$, où le circuit de contournement associé $CPC_j$, $CPC_k$, $CPC_l$, $CPC_m$, $CPC_p$, $CPC_q$, $CPC_r$ est déconnecté de la cellule j, k, l, m, p, q, r jusqu'à ce que la tension $V_{ji}$, $V_{ki}$, $V_{li}$, $V_{mi}$, $V_{pi}$, $V_{qi}$, $V_{ri}$ de la cellule j, k, l, m, p, q, r atteigne la tension prédéterminée VLIM. Pendant cette deuxième phase $C_{ji}$, $C_{ki}$, $C_{li}$, $C_{mi}$, $C_{pi}$, $C_{qi}$, $C_{ri}$, la cellule correspondante j, k, l, m, p, q, r est rechargée jusqu'à la tension prédéterminée VLIM par le courant de charge, qui est envoyé aux bornes 11, 12 par le chargeur 100.

Il se peut ainsi que toutes les deuxièmes phases associées $C_{ji}$, $C_{ki}$, $C_{li}$, $C_{mi}$, $C_{pi}$, $C_{qi}$, $C_{ri}$ finissent exactement en même temps dans l'idéal. Dans ce cas, il n'est pas nécessaire d'effectuer la troisième phase de maintien de charge après la deuxième phase pour les cellules. Toutefois, en pratique, les deuxièmes phases $C_{ji}$, $C_{ki}$, $C_{mi}$, $C_{li}$ peuvent ne pas se terminer toutes en même temps, c'est-à-dire qu'il peut y avoir la deuxième phase $C_{ri}$ qui se finit la dernière pour la cellule r par rapport aux autres cellules j, k, l, m, p, q. Dans ce cas, on prévoit pour toutes les cellules autres que la ou les cellules r dont la deuxième phase associée $C_{ri}$ se termine la dernière, une troisième phase de maintien de charge ayant une troisième durée de maintien de charge $M_{ji}$, $M_{ki}$, $M_{li}$, $M_{mi}$, $M_{pi}$, $M_{qi}$, respectivement pour les cellules j, k, l, m, p, q. Ceci équivaut au fait de faire suivre la deuxième phase $C_{ri}$ de la cellule r par une troisième phase associée $M_{ri} = 0$, c'est-à-dire de troisième durée $M_{ri}$ nulle de maintien de charge. Dans le mode de réalisation représenté, la fin de la

deuxième phase C<sub>ri</sub>, par exemple déclenchée par le fait que la au moins une cellule r atteint la dernière la tension prédéterminée VLIM lors de la connexion de son circuit de contournement CPC<sub>r</sub> ou par le fait que la troisième phase associée de maintien de charge de cette au moins une cellule r est de troisième durée M<sub>ri</sub> nulle, déclenche la fin de la troisième durée M<sub>ji</sub>, M<sub>ki</sub>, M<sub>li</sub>, M<sub>mi</sub>, M<sub>pi</sub>, M<sub>qi</sub> de la troisième phase de maintien de charge des autres cellules j, k, l, m, p, q. Le chargeur 100 peut alors être déconnecté des bornes 11, 12 de charge. Bien entendu, une troisième phase de maintien de charge M<sub>ri</sub> ayant une troisième durée de maintien de charge M<sub>ri</sub> non nulle pourrait être prévue, ce qui prolongerait d'autant les troisièmes phases des autres cellules. Bien entendu, la cellule r peut être différente des cellules j, k, m, l, p ou être l'une de ces cellules j, k, m, l, p.

Dans un mode de réalisation, le fait que la tension $V_{ji}$, $V_{ki}$, $V_{li}$, $V_{mi}$, $V_{pi}$, $V_{qi}$, $V_{ri}$ de la cellule j, k, l, m, p, q, r atteint la tension prédéterminée VLIM est détecté par l'organe de mesure de tension associé MES<sub>j</sub>, MES<sub>k</sub>, MES<sub>l</sub>, MES<sub>m</sub>, MES<sub>p</sub>, MES<sub>q</sub>, MES<sub>r</sub> en comparant la tension mesurée $V_{ji}$, $V_{ki}$, $V_{li}$, $V_{mi}$, $V_{pi}$, $V_{qi}$, $V_{ri}$ mesurée à cette tension prédéterminée VLIM.

Suivant un mode de réalisation, on mesure la troisième durée $M_{ji}$, $M_{kj}$, $M_{li}$, $M_{mi}$, $M_{pi}$, $M_{qi}$, $M_{ri}$ de connexion du circuit de contournement CPC<sub>J</sub>, CPC<sub>k</sub>, CPC<sub>l</sub>, CPC<sub>m</sub>, CPC<sub>p</sub>, CPC<sub>q</sub>, CPC<sub>r</sub> associé à la cellule j, k, l, m, p, q, r lors de la troisième phase $M_{ji}$, $M_{ki}$, $M_{li}$, $M_{mi}$, $M_{pi}$, $M_{qi}$, $M_{ri}$ de maintien de charge, par exemple à l'aide du compteur CT<sub>j</sub>, CT<sub>k</sub>, CT<sub>l</sub>, CT<sub>m</sub>, CT<sub>p</sub>, CT<sub>q</sub>, CT<sub>r</sub> et de l'horloge H.

Suivant un mode de réalisation, la première durée $TP_{ji}$, $TP_{ki}$, $TP_{li}$, $TP_{mi}$, $TP_{pi}$, $TP_{ri}$ prédéterminée de contournement préemptif associée à la cellule j, k, l, m, p, r pour la i-ème charge tient compte au moins de la deuxième durée $TP_{ji-1}$, $TP_{ki-1}$, $TP_{li-i}$, $TP_{mi-1}$, $TP_{pi-1}$, $TP_{ri-1}$ de connexion du circuit de contournement CPC<sub>J</sub>, CPC<sub>k</sub>, CPC<sub>l,</sub> CPC<sub>m</sub>, CPC<sub>p</sub>, CPC<sub>r</sub> associé à la cellule j, k, l, m, p, r lors de la première phase d'au moins une charge précédente, par exemple de la charge i-1, et de la troisième durée $M_{ji}$, $M_{ki}$, $M_{li}$, $M_{mi}$, $M_{pi}$, $M_{ri}$ de connexion du circuit de contournement CPCj associé à la cellule j, k, l, m, p, r lors de la troisième phase de maintien de charge de cette au moins une charge précédente, par exemple de la charge i-1.

Suivant un mode de réalisation, la première durée $TP_{ji}$, $TP_{ki}$, $TP_{li}$, $TP_{mi}$, $TP_{pi}$, $TP_{ri}$ de contournement préemptif, associée respectivement à la cellule j, k, l, m, p, r pour la i-ème charge est calculée en fonction au moins de la durée totale de connexion du circuit de contournement CPC<sub>j</sub>, CPC<sub>k</sub>, CPC<sub>l</sub>, CPC<sub>m</sub>, CPC<sub>p</sub>, CPC<sub>r</sub> associé à cette cellule j, k, l, m, p, r, qui a été déterminée lors de la (i-1)ème charge et qui est nécessaire pour que toutes les cellules aient atteint la tension prédéterminée VLIM, la première durée $TP_{ji}$, $TP_{ki}$, $TP_{li}$, $TP_{mi}$, $TP_{pi}$, $TP_{ri}$ de contournement préemptif pour la i-ème charge ayant été mémorisée dans une mémoire de la batterie lors de cette la (i-1)ème charge.

Dans un mode de réalisation, la première durée $TP_{ji}$ de contournement préemptif, associé respectivement à la cellule j pour la i-ème charge, est calculée de la manière suivante :

$$TP_{ji} = TP_{ji-1} + M_{ji-1} - min_j(TP_{ji-1} + M_{ji-1})$$

où $min_j (TP_{ji-1} + M_{ji-1})$ désigne le minimum de $TP_{ji-1} + M_{ji-1}$ sur les cellules j. De même, pour respectivement les autres cellules k, 1, m, p, q, r :

$$TP_{ki} = TP_{ki-1} + M_{ki-1} - min_j(TP_{ji-1} + M_{ji-1}),$$

$$TP_{li} = TP_{li-1} + M_{li-1} - min_j(TP_{ji-1} + M_{ji-1}),$$

$$TP_{mi} = TP_{mi-1} + M_{mi-1} - min_j(TP_{ji-1} + M_{ji-1}),$$

$$TP_{pi} = TP_{pi-1} + M_{pi-1} - min_j(TP_{ji-1} + M_{ji-1}),$$

$$TP_{qi} = TP_{qi-1} + M_{qi-1} - min_j(TP_{ji-1} + M_{ji-1}) = 0,$$

$$TP_{ri} = TP_{ri-1} + M_{ri-1} - min_j(TP_{ji-1} + M_{ji-1}).$$

Les moyens 200 de commande comportent des moyens 20 de calcul de la première durée $TP_{ji}$ de contournement

préemptif, associée respectivement à la cellule j pour la i-ème charge avec i $\geq$ 2 en fonction de la durée totale de connexion du circuit de contournement associé $CPC_j$ à cette cellule j, qui a été déterminée lors d'au moins une charge précédente et qui est nécessaire pour que toutes les cellules aient atteint la tension prédéterminée VLIM.

La batterie comporte au moins la mémoire 21 pour mémoriser la première durée $TP_{ji}$ de contournement préemptif pour la i-ème charge et/ou ladite durée totale de connexion du circuit de contournement $CPC_j$ à cette cellule j lors de cette au moins une charge précédente.

La batterie comprend un détecteur de la connexion des bornes 11, 12 de charge au chargeur 100. Par exemple, pour ce faire, on détecte la présence d'une prise de charge sur les bornes 11, 12, cette prise de charge devant connecter les bornes 11, 12 de la batterie aux bornes 101, 102 du chargeur 100, et/ou on détecte la fermeture d'une trappe devant être fermée pour effectuer la charge et/ou on détecte l'actionnement d'un organe mécanique devant être actionné pour effectuer la charge, et/ou on détecte la réception de trames d'état émanant du chargeur 100 via un bus de communication de la batterie.

Les moyens 200 de commande sont prévus pour déclencher pour la i-ème charge de la batterie, la connexion de la pluralité des cellules à leur circuit de contournement associé $CPC_j$ en réponse au fait que le détecteur a détecté que les bornes de charge sont connectées au chargeur, et pour maintenir la connexion de chaque cellule j à son circuit de contournement associé $CPC_j$ pendant la première durée $TP_{ji}$ de contournement préemptif, associée respectivement à la cellule j pour la i-ème charge de la batterie.

Les moyens 200 de commande sont prévus pour déconnecter à la fin de la première durée $TP_{ji}$ de contournement préemptif le circuit de contournement associé $CPC_j$ de chaque cellule j pendant une deuxième phase associée $C_{ji}$ pour la i-ème charge de la batterie jusqu'à ce que la tension $V_{ji}$ de la cellule j atteigne la tension prédéterminée VLIM.

Les figures 5 et 6 indiquent entre parenthèses, à titre d'exemple numérique illustratif, des valeurs numériques de ces premières et troisièmes durées, ainsi que de leur somme TP+M pour la charge i-1 et les valeurs numériques correspondante, calculées pour la première durée de contournement préemptif pour la charge i pour les cellules j, k, l, m, p, q, r.

Grâce à l'invention, on évite d'approvisionner en énergie électrique des cellules ayant déjà atteint la tension prédéterminée VLIM, ce qui évite de dégrader leurs propriétés et notamment d'accélérer leur vieillissement. Ainsi, grâce à l'invention, on parvient à faire se rapprocher la fin de la deuxième phase de charge $C_{ji}$ des cellules, ou on arrive à ce que cette deuxième phase $C_{ji}$ se termine pratiquement en même temps pour toutes les cellules j. On diminue également la durée $M_{ji}$ de la troisième phase de maintien de charge des cellules j, ce qui évite également de dégrader les propriétés des cellules.

En outre, le procédé suivant l'invention est auto-adaptatif. En effet, il s'adapte aux fluctuations de fonctionnement des cellules, notamment aux fluctuations de durée de charge des cellules jusqu'à atteindre leur tension prédéterminée VLIM. On arrive ainsi à ce que, au bout de quelques charges, voire de pratiquement deux charges, les deuxièmes phases de charge se terminent pratiquement toutes en même temps et que donc les troisièmes phases de maintien de charge puissent être très courtes.

De plus, le fait de faire commencer chaque charge par la première phase de contournement préemptif de pratiquement toutes les cellules permet de faire ce contournement lorsque les cellules ne sont pas chargées à leur tension prédéterminée VLIM, ce qui permet de ne pas trop les solliciter.

La diminution des troisièmes phases de maintien de charge des cellules permet d'éviter les microcycles de charge/décharge qui se produisent généralement en phase de maintien de charge et ainsi de limiter le vieillissement des cellules, sans pour autant augmenter le temps de charge de la batterie 10.

De plus, le courant envoyé dans les circuits CPCj de contournement étant moins important dans la première phase de contournement ayant lieu en début de charge, on dissipe moins de chaleur par effet Joule du fait de la connexion de ce circuit de contournement. On évite donc de perturber le fonctionnement des cellules de la batterie, du fait que l'on évite d'ajouter aux éléments de chauffe de la batterie une chauffe supplémentaire non maîtrisée engendrée par le circuit de contournement. On utilise aussi moins d'énergie pour charger la batterie.

Dans un mode de réalisation, pour éviter des microcycles de charge et de décharge supplémentaires, on procède par exemple à la déconnexion du chargeur 100 par rapport aux bornes 11, 12 de charge de la batterie 10, une fois que la batterie est considérée comme chargée, seuls les éléments de chauffe destinés à maintenir la batterie 10 à une température adaptée restant connectés au chargeur. Cela permet également de consommer moins d'énergie.

Dans ce qui précède, la tension prédéterminée VLIM est la tension pour laquelle on connecte à nouveau le circuit de contournement. La tension prédéterminée VLIM correspond ici par exemple également à la tension à laquelle on considère que la cellule élémentaire j est chargée (tension de seuil de charge) mais elle pourrait être différente de la tension de seuil de charge. Cette tension prédéterminée VLIM est par exemple une tension maximale prescrite de charge de la cellule j. La tension prédéterminée VLIM est par exemple identique pour toutes les cellules j ou peut être différente d'une cellule à l'autre. La tension de seuil de charge est par exemple identique pour toutes les cellules j ou peut être différente d'une cellule à l'autre.

Dans un mode de réalisation, la tension prédéterminée VLIM est paramétrable.

Dans un mode de réalisation, la tension de seuil de charge est paramétrable.La tension prédéterminée VLIM est par exemple enregistrée au préalable dans la mémoire 21.

La tension de seuil de charge est par exemple enregistrée au préalable dans la mémoire 21.

Dans les modes de réalisation où la troisième phase $M_{ji}$ de maintien de charge est prévue, cette troisième phase permet de corriger la durée $TP_{ji+1}$ de la charge suivante i+1.

Dans d'autres modes de réalisation, la première durée $TP_{ji}$ de contournement préemptif peut prendre en compte plusieurs premières phases $TP_j$ et plusieurs troisièmes phases $M_j$ de plusieurs charges précédentes, par exemple en prenant en compte des valeurs moyennes de durée de ces premières et troisièmes phases.

Le procédé peut également comprendre une seule étape de mesure indiquée ci-dessus lors de la première charge, les autres charges étant effectuées à partir des données mesurées lors de cette étape de mesure (par exemple, la première). Les différentes durées pourraient également être déterminées à partir de différentes données théoriques relatives aux cellules. Ces modes de réalisation ne sont toutefois pas les modes de réalisation préférentiels puisqu'ils ne prennent pas en compte l'évolution des cellules au cours de leur vie.

On voit à la figure 7 que, lors de la première charge, les cellules n'atteignent pas toutes en même temps la tension prédéterminée VLIM et ont donc des troisièmes phases de maintien de charge ne commençant pas en même temps, du fait que les courbes de tension des cellules représentées à cette figure ne se superposent pas.

A la figure 8, on voit que, pour la i-ème charge, les courbes de tension se superposent presque, et bien plus qu'à la figure 7, et que les cellules atteignent leur tension prédéterminée VLIM presque en même temps et ont donc des troisièmes phases de maintien de charge commençant presque en même temps. Cela prouve bien l'efficacité du système.

Dans un autre mode de réalisation, la première durée $TP_{ji}$ de contournement préemptif, associée respectivement à la cellule j pour la i-ème charge, est calculée de la manière suivante :

$$TP_{ji} = a.(TP_{ji-1} + M_{ji-1}) - b.\ \min_j(TP_{ji-1} + M_{ji-1})$$

où $\min_j (TP_{ji-1} + M_{ji-1})$ désigne le minimum de $TP_{ji-1} + M_{ji-1}$ sur les cellules j, et où a et b sont des coefficients prescrits non nuls. Ces coefficients sont par exemple relatifs au niveau de charge de la batterie lors de sa connexion au chargeur.

## Revendications

1. Procédé de charge d'une batterie,
   la batterie (10) comportant une pluralité de cellules (j) rechargeables, des bornes (11, 12) de charge des cellules, aptes à être connectées à un chargeur (100), un circuit (CPC$_j$) de contournement associé à chaque cellule (j), des éléments (SW$_j$) de commutation permettant de connecter et de déconnecter chaque cellule (j) à son circuit (CPC$_j$) de contournement associé et des moyens (20) de commande des éléments (SW$_j$) de commutation,
   **caractérisé en ce que** pour effectuer la i-ème charge de la batterie, avec i supérieur ou égal à deux,
   on détecte la connexion des bornes de charge au chargeur, la connexion des bornes de charge au chargeur ayant été détectée déclenchant, lors d'une première phase, la connexion de cellules (j) à leur circuit de contournement associé (CPC$_j$) respectivement pendant une première durée (TP$_{ji}$) de contournement préemptif, associée respectivement à la cellule (j),

   - puis, pour chaque cellule (j), une fois la première durée (TP$_{ji}$) écoulée, on déconnecte, lors d'une deuxième phase associée (C$_{ji}$), le circuit de contournement associé (CPC$_j$) de la cellule (j) jusqu'à ce que la tension (V$_{ji}$) de la cellule (j) atteigne une tension prédéterminée (VLIM), qui est prescrite pour la cellule (j) et qui est non nulle, la première durée (TP$_{ji}$) de contournement préemptif, associée respectivement à la cellule (j) pour la i-ème charge, ayant été calculée en fonction de la durée totale de connexion, lors d'au moins une charge précédente, du circuit de contournement (CPC$_j$) associé à cette cellule (j) jusqu'à ce que toutes les cellules aient atteint la tension prédéterminée (VLIM),
   au moins une durée associée à la cellule (j) permettant de déterminer :

     - la première durée (TP$_{ji}$) de contournement préemptif pour la i-ème charge, et/ou
     - ladite durée totale de connexion du circuit de contournement (CPC$_j$) associée à cette cellule (j) lors de cette au moins une charge précédente,
     ayant été mémorisée dans une mémoire (21) de la batterie lors de cette au moins une charge précédente.

2. Procédé suivant la revendication 1, **caractérisé en ce que** pour au moins l'une des cellules (j), à la fin de la deuxième phase, le circuit de contournement associé (CPC$_j$) est connecté à la cellule (j) pour que la tension (V$_{ji}$) de la cellule (j) ne dépasse pas une tension de seuil de charge (VLIM) pendant une troisième phase (M$_{ji}$) associée de maintien de charge au moins jusqu'à ce que les tensions (V$_{ji}$) des cellules (j) aient toutes atteint la tension prédéterminée (VLIM).

3. Procédé suivant la revendication 2, **caractérisé en ce que** l'on mesure une troisième durée (M$_{ji}$) de connexion du circuit de contournement associé (CPC$_j$) à la cellule (j) lors de la troisième phase,
la première durée (TP$_{ji}$) prédéterminée de contournement préemptif associée à la cellule (j) pour la i-ème charge tenant compte au moins de la première durée (TP$_{ji-1}$) de connexion du circuit de contournement associé (CPC$_j$) à la cellule (j) lors de la première phase d'au moins une charge précédente et de la troisième durée (M$_{ji-1}$) de connexion du circuit de contournement associé (CPC$_j$) à la cellule (j) lors de la troisième phase de ladite au moins une charge précédente.

4. Procédé suivant la revendication 3, **caractérisé en ce que** chaque cellule (j) est associée à un élément (MES$_j$) de mesure de la tension (V$_{ji}$) de la cellule (j) et à un compteur (CT$_j$) de la troisième durée (M$_{ji}$) de contournement de la troisième phase (M$_{ji}$) de contournement, l'élément (MES$_j$) de mesure étant apte à comparer la tension (V$_{ji}$) de la cellule (j) mesurée à la tension prédéterminée (VLIM) et à déclencher le comptage par le compteur (CT$_j$) de la troisième durée (M$_{ji}$) de contournement lorsque la tension (V$_{ji}$) de la cellule (j) a atteint la tension prédéterminée (VLIM).

5. Procédé suivant la revendication 4, dans lequel les compteurs (CT$_j$) sont commandés pour compter comme fin de la troisième durée (M$_{ji}$) de contournement le moment à partir duquel toutes les cellules ont atteint la tension prédéterminée (VLIM).

6. Procédé suivant l'une quelconque des revendications précédentes, **caractérisé en ce que** la première durée (TP$_{ji}$) de contournement préemptif, associée respectivement à la cellule (j) pour la i-ème charge, est calculée en fonction de la durée totale de connexion, lors de la i-1 ème charge, du circuit de contournement (CPC$_j$) associé à cette cellule (j) jusqu'à ce que toutes les cellules aient atteint la tension prédéterminée (VLIM).

7. Procédé suivant l'une quelconque des revendications précédentes, **caractérisé en ce que** ladite au moins une durée associée à la cellule (j) permettant de déterminer :

   - la première durée (TP$_{ji}$) de contournement préemptif pour la i-ème charge, et/ou
   - ladite durée totale de connexion du circuit de contournement (CPC$_j$) associé à cette cellule (j) lors de la i-1 ème charge,
   a été mémorisée dans une mémoire (21) de la batterie lors de la i-1 ème charge.

8. Procédé suivant l'une quelconque des revendications précédentes, **caractérisé en ce que** l'on mémorise lors de ladite au moins une charge précédente, comme durée associée à la cellule (j), au moins la première durée (TP$_{ji}$) de contournement préemptif, associée respectivement à la cellule (j) pour la i-ème charge.

9. Procédé suivant l'une quelconque des revendications précédentes, **caractérisé en ce que** l'on mémorise lors de ladite au moins une charge précédente, comme durée associée à la cellule (j), au moins ladite durée totale de connexion du circuit de contournement (CPC$_j$) associé à cette cellule (j) lors de cette au moins une charge précédente.

10. Procédé suivant la revendication 9, **caractérisé en ce que**
la première durée TP$_{ji}$ de contournement préemptif, associée respectivement à la cellule j pour la i-ème charge, est calculée de la manière suivante :

$$TP_{ji} = TP_{ji-1} + M_{ji-1} - \min_j(TP_{ji-1} + M_{ji-1})$$

où min$_j$ (TP$_{ji-1}$ + M$_{ji-1}$) désigne le minimum de TP$_{ji-1}$ + M$_{ji-1}$ sur les cellules j.

11. Procédé suivant la revendication 9, **caractérisé en ce que**
la première durée TP$_{ji}$ de contournement préemptif, associée respectivement à la cellule j pour la i-ème charge, est calculée de la manière suivante :

$$TP_{ji} = a.(TP_{ji-1} + M_{ji-1}) - b. \min_j(TP_{ji-1} + M_{ji-1})$$

où $\min_j (TP_{ji-1} + M_{ji-1})$ désigne le minimum de $TP_{ji-1} + M_{ji-1}$ sur les cellules j, et où a, b sont des coefficients prescrits non nuls.

12. Procédé selon la revendication précédente, dans lequel les coefficients a et b sont déterminés en fonction du niveau de charge de la batterie lorsque la connexion de celle-ci au chargeur est détectée.

13. Procédé suivant l'une quelconque des revendications précédentes, **caractérisé en ce que** pour la première charge de chaque cellule (j) de la batterie,
on détecte la connexion des bornes (11, 12) de charge au chargeur, la connexion des bornes (11, 12) de charge au chargeur ayant été détectée déclenchant pendant une deuxième phase associée ($C_{j1}$) la déconnexion de chaque cellule (j) par rapport à son circuit de contournement associé ($CPC_j$) pour charger la cellule (j) jusqu'à ce que la tension respective ($V_{j1}$) de la cellule (j) atteigne la tension (VLIM) prédéterminée,
puis pour au moins l'une des cellules (j), à la fin de la deuxième phase associée ($C_{j1}$), le circuit de contournement associé ($CPC_j$) est connecté à la cellule (j) pour que la tension ($V_{j1}$) de la cellule (j) ne dépasse pas la tension de seuil de charge (VLIM) pendant une troisième phase associée ($M_{ji}$) de maintien de charge jusqu'à ce que les tensions ($V_{j1}$) des cellules (j) aient toutes atteint la tension prédéterminée (VLIM),
la première durée ($TP_{j2}$) de contournement préemptif associée respectivement à la cellule (j) et valable pour au moins la deuxième charge correspondant à la troisième durée ($M_{j1}$) de connexion du circuit de contournement associé ($CPC_j$) à la cellule (j) lors de la troisième phase ($M_{j1}$) de la première charge.

14. Procédé suivant l'une quelconque des revendications précédentes, **caractérisé en ce que** ladite tension prédéterminée (VLIM) est une tension inférieure ou égale à la tension de seuil de charge qui est prescrite pour la cellule (j) et qui est non nulle.

15. Batterie (10) comportant une pluralité de cellules (j) rechargeables, des bornes (11, 12) de charge des cellules, aptes à être connectées à un chargeur (100), un circuit ($CPC_j$) de contournement associé à chaque cellule (j), des éléments ($SW_j$) de commutation permettant de connecter et de déconnecter chaque cellule (j) à son circuit ($CPC_j$) de contournement associé et des moyens (20) de commande des éléments ($SW_j$) de commutation, des moyens de mesure de la tension ($V_{ji}$) de chaque cellule (j),
**caractérisé en ce que** les moyens (200) de commande comportent des moyens (20) de calcul d'une première durée ($TP_{ji}$) de contournement préemptif, associée respectivement à la cellule (j) pour la i-ème charge avec $i \geq 2$ en fonction de la durée totale de connexion, lors d'au moins une charge précédente, du circuit de contournement associé ($CPC_j$) à cette cellule (j) jusqu'à ce que toutes les cellules aient atteint une tension prédéterminée (VLIM), la batterie comportant au moins une mémoire (21) pour mémoriser au moins une durée associé à la cellule (j) et permettant de déterminer :

- la première durée ($TP_{ji}$) de contournement préemptif pour la i-ème charge, et/ou
- ladite durée totale de connexion du circuit de contournement ($CPC_j$) à cette cellule (j) lors de cette au moins une charge précédente,
la batterie comprenant un détecteur de la connexion des bornes (11, 12) de charge au chargeur (100),
les moyens (200) de commande étant prévus pour déclencher pour la i-ème charge de la batterie, la connexion de la pluralité des cellules à leur circuit de contournement associé ($CPC_j$) en réponse au fait que le détecteur a détecté que les bornes de charge sont connectées au chargeur, et pour maintenir la connexion de chaque cellule (j) à son circuit de contournement associé ($CPC_j$) pendant la première durée ($TP_{ji}$) de contournement préemptif, associée respectivement à la cellule (j) pour la i-ème charge de la batterie,
les moyens (200) de commande étant prévus pour déconnecter à la fin de la première durée ($TP_{ji}$) de contournement préemptif le circuit de contournement associé ($CPC_j$) de chaque cellule (j) pendant une deuxième phase associée ($C_{ji}$) pour la i-ème charge de la batterie jusqu'à ce que la tension ($V_{ji}$) de la cellule (j) atteigne la tension prédéterminée (VLIM), qui est prescrite pour la cellule (j) et qui est non nulle.

**Patentansprüche**

1. Batterieladeverfahren,

wobei die Batterie (10) eine Vielzahl von aufladbaren Zellen (j), Klemmen (11, 12) zum Laden der Zellen, die dazu geeignet sind, an ein Ladegerät (100) angeschlossen zu werden, eine Umgehungsschaltung ($CPC_j$), die mit jeder Zelle (j) verknüpft ist, Schaltelemente ($SW_j$), die es ermöglichen, jede Zelle ($_j$) an ihre verknüpfte Umgehungsschaltung ($CPC_j$) anzuschließen und davon zu trennen, und Mittel (20) zum Steuern der Schaltelemente ($SW_j$) umfasst, **dadurch gekennzeichnet, dass** zum Ausführen des i-ten Aufladens der Batterie, wobei i größer oder gleich zwei ist, der Anschluss der Ladeklemmen an das Ladegerät erkannt wird, wobei die Tatsache, dass der Anschluss der Ladeklemmen an das Ladegerät erkannt wurde, bei einer ersten Phase den Anschluss von Zellen (j) an ihre verknüpfte Umgehungsschaltung ($CPC_j$) jeweils während einer ersten Dauer ($TP_{ji}$) einer präemptiven Umgehung, die jeweils mit der Zelle (j) verknüpft ist, auslöst,

und dann für jede Zelle (j), nachdem die erste Dauer ($TP_{ji}$) abgelaufen ist, bei einer zweiten verknüpften Phase ($C_{ji}$) die verknüpfte Umgehungsschaltung ($CPC_j$) von der Zelle (j) getrennt wird, bis die Spannung ($V_{ji}$) der Zelle (j) eine vorbestimmte Spannung (VLIM) erreicht, die für die Zelle (j) vorgeschrieben ist und die ungleich null ist,

wobei die erste Dauer ($TP_{ji}$) einer präemptiven Umgehung, die jeweils mit der Zelle (j) für die i-te Ladung verknüpft ist, in Abhängigkeit von der gesamten Anschlussdauer bei mindestens einer vorhergehenden Ladung der Umgehungsschaltung ($CPC_j$), die mit dieser Zelle (j) verknüpft ist, berechnet wurde, bis alle Zellen die vorbestimmte Spannung (VLIM) erreicht haben,

wobei mindestens eine Dauer, die mit der Zelle (j) verknüpft ist und es ermöglicht:

- die erste Dauer ($TP_{ji}$) einer präemptiven Umgehung für die i-te Ladung
und/oder
- die gesamte Anschlussdauer der Umgehungsschaltung ($CPC_j$), die mit dieser Zelle (j) verknüpft ist, bei dieser mindestens einen vorhergehenden Ladung

zu bestimmen, in einem Speicher (21) der Batterie bei dieser mindestens einen vorhergehenden Ladung gespeichert wurde.

2. Verfahren nach Anspruch 1, **dadurch gekennzeichnet, dass** für mindestens eine der Zellen (j) am Ende der zweiten Phase die verknüpfte Umgehungsschaltung ($CPC_j$) an die Zelle (j) angeschlossen wird, damit die Spannung ($V_{ji}$) der Zelle (j) eine Ladeschwellenspannung (VLIM) während einer verknüpften dritten Ladungserhaltungsphase ($M_{ji}$), mindestens bis die Spannungen ($V_{ji}$) der Zellen (j) alle die vorbestimmte Spannung (VLIM) erreicht haben, nicht überschreitet.

3. Verfahren nach Anspruch 2, **dadurch gekennzeichnet, dass** eine dritte Anschlussdauer ($M_{ji}$) der verknüpften Umgehungsschaltung ($CPC_j$) an die Zelle (j) bei der dritten Phase gemessen wird, wobei die erste vorbestimmte Dauer ($TP_{ji}$) einer präemptiven Umgehung, die mit der Zelle (j) für die i-te Ladung verknüpft ist, mindestens die erste Anschlussdauer ($TP_{ji-1}$) der verknüpften Umgehungsschaltung ($CPC_j$) an die Zelle (j) bei der ersten Phase mindestens einer vorhergehenden Ladung und die dritte Anschlussdauer ($M_{ji-1}$) der verknüpften Umgehungsschaltung ($CPC_j$) an die Zelle (j) bei der dritten Phase der mindestens einen vorhergehenden Ladung berücksichtigt.

4. Verfahren nach Anspruch 3, **dadurch gekennzeichnet, dass** jede Zelle (j) mit einem Element ($MES_j$) zum Messen der Spannung ($V_{ji}$) der Zelle (j) und mit einem Zähler ($CT_j$) der dritten Umgehungsdauer ($M_{ji}$) der dritten Umgehungsphase ($M_{ji}$) verknüpft ist, wobei das Messelement ($MES_j$) geeignet ist, um die Spannung ($V_{ji}$) der gemessenen Zelle (j) mit der vorbestimmten Spannung (VLIM) zu vergleichen und die Zählung durch den Zähler ($CT_j$) der dritten Umgehungsdauer ($M_{ji}$) auszulösen, wenn die Spannung ($V_{ji}$) der Zelle (j) die vorbestimmte Spannung (VLIM) erreicht hat.

5. Verfahren nach Anspruch 4, wobei die Zähler ($CT_j$) gesteuert werden, um als Ende der dritten Umgehungsdauer ($M_{ji}$) den Moment zu zählen, an dem alle Zellen die vorbestimmte Spannung (VLIM) erreicht haben.

6. Verfahren nach einem der vorhergehenden Ansprüche, **dadurch gekennzeichnet, dass** die erste Dauer ($TP_{ji}$) einer präemptiven Umgehung, die jeweils mit der Zelle (j) für die i-te Ladung verknüpft ist, in Abhängigkeit von der gesamten Anschlussdauer bei der Ladung i-1 der Umgehungsschaltung ($CPC_j$), die mit dieser Zelle (j) verknüpft ist, berechnet wird, bis alle Zellen die vorbestimmte Spannung (VLIM) erreicht haben.

7. Verfahren nach einem der vorhergehenden Ansprüche, **dadurch gekennzeichnet, dass** die mindestens eine Dauer, die mit der Zelle (j) verknüpft ist und es ermöglicht:

- die erste Dauer ($TP_{ji}$) einer präemptiven Umgehung für die i-te Ladung

und/oder

- die gesamte Anschlussdauer der Umgehungsschaltung (CPC$_j$), die mit dieser Zelle (j) bei der Ladung i-1 verknüpft ist,

zu bestimmen, in einem Speicher (21) der Batterie bei der Ladung i-1 gespeichert wurde.

8. Verfahren nach einem der vorhergehenden Ansprüche, **dadurch gekennzeichnet, dass** bei der mindestens einen vorhergehenden Ladung als die Dauer, die mit der Zelle (j) verknüpft ist, mindestens die erste Dauer (TP$_{ji}$) einer präemptiven Umgehung, die jeweils mit der Zelle (j) für die i-te Ladung verknüpft ist, gespeichert wird.

9. Verfahren nach einem der vorhergehenden Ansprüche, **dadurch gekennzeichnet, dass** bei der mindestens einen vorhergehenden Ladung als die Dauer, die mit der Zelle (j) verknüpft ist, mindestens die gesamte Anschlussdauer der Umgehungsschaltung (CPC$_j$), die mit dieser Zelle (j) verknüpft ist, bei dieser mindestens einen vorhergehenden Ladung gespeichert wird.

10. Verfahren nach Anspruch 9, **dadurch gekennzeichnet, dass**
die erste Dauer TP$_{ji}$ einer präemptiven Umgehung, die jeweils mit der Zelle j für die i-te Ladung verknüpft ist, folgendermaßen berechnet wird:

$$TP_{ji} = TP_{ji-1} + M_{ji-1} - \min_j(TP_{ji-1} + M_{ji-1}),$$

wobei min$_j$ (TP$_{ji-1}$ + M$_{ji-1}$) das Minimum von TP$_{ji-1}$ + M$_{ji-1}$ für die Zellen j bezeichnet.

11. Verfahren nach Anspruch 9, **dadurch gekennzeichnet, dass**
die erste Dauer TP$_{ji}$ einer präemptiven Umgehung, die jeweils mit der Zelle j für die i-te Ladung verknüpft ist, folgendermaßen berechnet wird:

$$TP_{ji} = a.(TP_{ji-1} + M_{ji-1}) - b.\min_j(TP_{ji-1} + M_{ji-1}),$$

wobei min$_j$ (TP$_{ji-1}$ + M$_{ji-1}$) das Minimum von TP$_{ji-1}$ + M$_{ji-1}$ für die Zellen j bezeichnet, und wobei a, b, vorgeschriebene Koeffizienten ungleich null sind.

12. Verfahren nach dem vorhergehenden Anspruch, wobei die Koeffizienten a und b in Abhängigkeit von dem Ladezustand der Batterie bestimmt werden, wenn der Anschluss derselben an das Ladegerät erkannt wird.

13. Verfahren nach einem der vorhergehenden Ansprüche, **dadurch gekennzeichnet, dass** für die erste Ladung jeder Zelle (j) der Batterie
der Anschluss der Ladeklemmen (11, 12) an das Ladegerät erkannt wird, wobei die Tatsache, dass der Anschluss der Ladeklemmen (11, 12) an das Ladegerät erkannt wurde, während einer verknüpften zweiten Phase (C$_{ji}$) das Trennen jeder Zelle (j) von ihrer verknüpften Umgehungsschaltung (CPC$_j$) auslöst, um die Zelle (j) zu laden, bis die jeweilige Spannung (V$_{ji}$) der Zelle (j) die vorbestimmte Spannung (VLIM) erreicht,
und dann für mindestens eine der Zellen (j) am Ende der verknüpften zweiten Phase (C$_{ji}$) die verknüpfte Umge-hungsschaltung (CPC$_j$) an die Zelle (j) angeschlossen wird, damit die Spannung (V$_{ji}$) der Zelle (j) die Ladeschwellenspannung (VLIM) während einer dritten verknüpften Ladungserhaltungsphase (M$_{ji}$) nicht überschreitet, bis die Spannungen (V$_{ji}$) der Zellen (j) alle die vorbestimmte Spannung (VLIM) erreicht haben,
wobei die erste Dauer (TP$_{j2}$) einer präemptiven Umgehung, die jeweils mit der Zelle (j) verknüpft ist und für mindestens die zweite Ladung gültig ist, der dritten Anschlussdauer (mai) der verknüpften Umgehungsschaltung (CPC$_j$) an die Zelle (j) bei der dritten Phase (M$_{ji}$) der ersten Ladung entspricht.

14. Verfahren nach einem der vorhergehenden Ansprüche, **dadurch gekennzeichnet, dass** die vorbestimmte Spannung (VLIM) eine Spannung kleiner oder gleich der Ladeschwellenspannung ist, die für die Zelle (j) vorgeschrieben ist und die ungleich null ist.

15. Batterie (10), umfassend eine Vielzahl von aufladbaren Zellen (j), Klemmen (11, 12) zum Laden der Zellen, die dazu geeignet sind, an ein Ladegerät (100) angeschlossen zu werden, eine Umgehungsschaltung (CPC$_j$), die mit jeder

Zelle (j) verknüpft ist, Schaltelemente (SW$_j$), die es ermöglichen, jede Zelle (j) an ihre verknüpfte Umgehungsschaltung (CPC$_j$) anzuschließen und davon zu trennen, Mittel (20) zum Steuern der Schaltelemente (SW$_j$) und Mittel zum Messen der Spannung (V$_{ji}$) jeder Zelle (j),

**dadurch gekennzeichnet, dass** die Steuermittel (200) Mittel (20) zum Berechnen einer ersten Dauer (TP$_{ji}$) einer präemptiven Umgehung umfassen, die jeweils mit der Zelle (j) für die i-te Ladung verknüpft ist, wobei i ≥ 2 in Abhängigkeit von der gesamten Anschlussdauer bei mindestens einer vorhergehenden Ladung der verknüpften Umgehungsschaltung (CPC$_j$) an diese Zelle (j), bis alle Zellen eine vorbestimmte Spannung (VLIM) erreicht haben, wobei die Batterie mindestens einen Speicher (21) umfasst, um mindestens eine Dauer zu speichern, die mit der Zelle (j) verknüpft ist, und es ermöglicht:

- die erste Dauer (TP$_{ji}$) einer präemptiven Umgehung für die i-te Ladung, und/oder
- die gesamte Anschlussdauer der Umgehungsschaltung (CPC$_j$) an diese Zelle (j) bei dieser mindestens einen vorhergehenden Ladung

zu bestimmen, wobei die Batterie einen Detektor des Anschlusses der Ladeklemmen (11, 12) an das Ladegerät (100) umfasst,

wobei die Steuermittel (200) bereitgestellt werden, um für die i-te Ladung der Batterie, den Anschluss der Vielzahl der Zellen an ihre verknüpfte Umgehungsschaltung (CPC$_j$) als Reaktion auf die Tatsache, dass der Detektor erkannt hat, dass die Ladeklemmen an das Ladegerät angeschlossen sind, auszulösen und um den Anschluss jeder Zelle (j) an ihre verknüpfte Umgehungsschaltung (CPC$_j$) während der ersten Dauer (TP$_{ji}$) einer präemptiven Umgehung, die jeweils mit der Zelle (j) für die i-te Ladung der Batterie verknüpft ist, aufrechtzuerhalten,

wobei die Steuermittel (200) bereitgestellt werden, um am Ende der ersten Dauer (TP$_{ji}$) einer präemptiven Umgehung die verknüpfte Umgehungsschaltung (CPC$_j$) von jeder Zelle (j) während einer zweiten verknüpften Phase (C$_{ji}$) für die i-te Ladung der Batterie zu trennen, bis die Spannung (V$_{ji}$) der Zelle (j) die vorbestimmte Spannung (VLIM) erreicht, die für die Zelle (j) vorgeschrieben ist und die ungleich null ist.

## Claims

1. A method for charging a battery,

   the battery (10) comprising a plurality of rechargeable cells (j), terminals (11, 12) for charging the cells and able to be connected to a charger (100), a bypass circuit (CPC$_j$) associated with each cell (j), switching elements (SW$_j$) allowing the connection and disconnection of each cell (j) to and from its associated bypass circuit (CPC$_j$) and control means (20) to control the switching elements (SW$_j$),

   **characterized in that** to perform the ith charging of the battery with i greater than or equal to two,

   the connection of the charging terminals to the charger is detected,

   the detection of the connecting of the charging terminals to the charger triggering, at a first phase, the connection of the cells (j) to their associated bypass circuit (CPC$_j$) for a respective first pre-emptive bypass time (TP$_{ji}$) associated with cell (j) respectively;

   - next, for each cell (j), once the first time (TP$_{ji}$) has elapsed, at a second associated phase (C$_{ji}$) the associated bypass circuit (CPC$_j$) is disconnected from cell (j) until the voltage (V$_{ji}$) of the cell (j) reaches a pre-set voltage (VLIM) which is prescribed for the cell (j) and is nonzero;

   the first pre-emptive bypass time (TP$_{ji}$), respectively associated with cell (j) for the ith charging, having been calculated as a function of the total connection time, during at least one previous charging, of the associated bypass circuit (CPC$_j$) to this cell (j) until all the cells reached the pre-set voltage (VLIM),

   at least one time period associated with the cell (j) allowing the determination of:

   - the first pre-emptive bypass time (TP$_{ji}$) for the ith charging, and/or
   - said total connection time of the associated bypass circuit (CPC$_j$) to this cell (j) during this at least one previous charging,

   having been memorised in a memory (21) of the battery during this at least one previous charging.

2. The method according to claim 1, **characterized in that** for at least one of the cells (j), at the end of the second phase, the associated bypass circuit (CPC$_j$) is connected to the cell (j) so that the voltage (V$_{ji}$) of the cell (j) does not exceed a threshold charge voltage (VLIM) during an associated charge maintaining third phase (M$_{ji}$) at least until the voltages (V$_{ji}$) of the cells (j) have all reached the pre-set voltage (VLIM).

3. The method according to claim 2, **characterized in that** a third connection time ($M_{ji}$) of the associated bypass circuit ($CPC_j$) to the cell (j) during the third phase is measured, the first pre-determined pre-emptive bypass time ($TP_{ji}$) associated with the cell (j) for the ith charging at least taking into account the first connection time ($TP_{ji-1}$) of the associated bypass circuit ($CPC_j$) to the cell (j) during the first phase of at least one previous charging and the third connection time ($M_{ji-1}$) of the associated bypass circuit ($CPC_j$) to the cell (j) during the third phase of said at least one previous charging.

4. The method according claim 3, **characterized in that** each cell (j) is associated with a measuring element ($MES_j$) to measure the voltage ($V_{ji}$) of the cell (j) and with a counter ($CT_j$) to count the third bypass time ($M_{ji}$) of the third bypass phase ($M_{ji}$), the measuring element ($MES_j$) being capable of comparing the measured voltage ($V_{ji}$) of the cell (j) with the pre-set voltage (VLIM) and of triggering counting by the counter ($CT_j$) of the third bypass time ($M_{ji}$) when the voltage ($V_{ji}$) of the cell (j) has reached the pre-set voltage (VLIM).

5. The method according to claim 4, wherein the counters ($CT_j$) are controlled to count, as end of the third bypass time ($M_{ji}$), the instant from which all the cells have reached the pre-set voltage (VLIM).

6. The method according to any of the preceding claims, **characterized in that** the first pre-emptive bypass time ($TP_{ji}$) respectively associated with cell (j) for the ith charging is calculated as a function of the total connection time, during the i-1th charging, of the associated bypass circuit ($CPC_j$) to this cell (j) until all the cells reached the pre-set voltage (VLIM).

7. The method according to any one of the preceding claims, **characterized in that** the said at least one time period associated with the cell (j) allowing the determination of:

   - the first pre-emptive bypass time ($TP_{ji}$) for the ith charging, and/or
   - said total connection time of the associated bypass circuit ($CPC_j$) to this cell (j) during the i-1th charging,
   has been memorised in a memory (21) of the battery during the i-1th charging.

8. The method according to any one of the preceding claims, **characterized in that**, during the said at last one previous charging, the period of time associated with the cell (j) that is memorised is at least the first pre-emptive bypass time ($TP_{ji}$) respectively associated with the cell (j) for the ith charging.

9. The method according to any one of the preceding claims, **characterized in that**, during the said at least one previous charging, the period of time associated with the cell (j) that is memorised is at least the said total connection time of the associated bypass circuit ($CPC_j$) to this cell(j) during this at least one previous charging.

10. The method according to claim 9, **characterized in that**:

    the first pre-emptive bypass time $TP_{ji}$ respectively associated with the cell j for the ith charging is calculated as follows:

$$TP_{ji} = TP_{ji-1} + M_{ji-1} - \min_j(TP_{ji-1} + M_{ji-1})$$

    where $\min_j(TP_{ji-1} + M_{ji-1})$ designates the minimum of $TP_{ji-1} + M_{ji-1}$ on the cells j.

11. The method according to claim 9, **characterized in that**:

    the first pre-emptive bypass time $TP_{ji}$ respectively associated with the cell j for the ith charging is calculated as follows:

$$TP_{ji} = a.(TP_{ji-1} + M_{ji-1}) - b.\min_j(TP_{ji-1} + M_{ji-1})$$

    where $\min_j(TP_{ji-1} + M_{ji-1})$ designates the minimum of $TP_{ji-1} + M_{ji-1}$ on the cells j, and where a, b are prescribed nonzero coefficients.

**12.** The method according to the preceding claims, wherein the coefficients a and b are determined as a function of the charge level of the battery when the connection thereof to the charger is detected.

**13.** The method according to any one of the preceding claims, **characterized in that** for the first charging of each cell (j) of the battery:

the connection of the charging terminals (11, 12) to the charger is detected,
the detection of the connecting of the charging terminals (11, 12) to the charger triggering, during a second associated phase ($C_{j1}$), the disconnection of each cell (j) from its associated bypass circuit ($CPC_j$) to charge the cell (j) until the respective voltage ($V_{j1}$) of the cell (j) reaches the pre-set voltage (VLIM);
then, for at least one of the cells (j), at the end of the second associated phase ($C_{j1}$), the associated bypass circuit ($CPC_j$) is connected to the cell (j) so that the voltage ($V_{j1}$) of the cell (j) does not exceed the threshold charge voltage (VLIM) during an associated charge maintaining third phase ($M_{j1}$) until the voltages ($V_{j1}$) of the cells (j) have all reached the pre-set voltage (VLIM),
the first pre-emptive bypass time ($TP_{j2}$) respectively associated with the cell (j), and valid for at least the second charging, corresponding to the third connection time ($M_{j1}$) of the associated bypass circuit ($CPC_j$) to the cell (j) during the third phase ($M_{j1}$) of the first charging.

**14.** The method according to any one of the preceding claims, **characterized in that** the said pre-set voltage (VLIM) is a voltage lower than or equal to the threshold charge voltage which is prescribed for the cell (j) and which is nonzero.

**15.** A battery (10) comprising a plurality of rechargeable cells (j), terminals (11, 12) for charging the cells and able to be connected to a charger (100), a bypass circuit ($CPC_j$) associated with each cell (j), switching elements ($SW_j$) allowing each cell (j) to be connected and disconnected to and from its associated bypass circuit ($CPC_j$) and control means (20) to control the switching elements ($SW_j$), means for measuring the voltage ($V_{ji}$) of each cell (j),
**characterized in that** the control means (200) comprise means (20) to compute a first pre-emptive bypass time ($TP_{ji}$) respectively associated with the cell (j) for the $i^{th}$ charging where $i \geq 2$ as a function of the total connection time, during at least one previous charging, of the associated bypass circuit ($CPC_j$) to this cell (j) until all the cells reached a pre-set voltage (VLIM),
the battery comprising at least one memory (21) to memorise at least one time period associated with the cell (j) and allowing the determination of:

- the first pre-emptive bypass time ($TP_{ji}$) for the $i^{th}$ charging, and/or
- said total connection time of the bypass circuit ($CPC_j$) to this cell during this at least one previous charging,
the battery comprising a detector to detect connection of the charging terminals (11, 12) to the charger (100), the control means (200) being designed to trigger, for the $i^{th}$ charging of the battery, the connection of the plurality of cells to their associated bypass circuit ($CPC_j$) in response to the fact that the detector has detected that the charging terminals are connected to the charger, and to maintain the connection of each cell (j) to its associated bypass circuit ($CPC_j$) during the first pre-emptive bypass time ($TP_{ji}$) respectively associated with the cell (j) for the $i^{th}$ charging of the battery,
the control means (200) being designed to disconnect, at the end of the first pre-emptive bypass time ($TP_{ji}$), the associated bypass circuit ($CPC_j$) from each cell (j) during a second associated phase ($C_{ji}$) for the $i^{th}$ charging of the battery until the voltage ($V_{ji}$) of the cell (j) reaches the pre-set voltage (VLIM) which is prescribed for the cell (j) and is nonzero.

FIG. 1

EP 2 873 133 B1

FIG. 2

FIG. 3

FIG. 4

TP+M

$TP_{ji-1}$        $C_{ji-1}$        $M_{ji=1}$

$t_{i-1}$    (3.5)        ×        (2)        (5.5)

$TP_{ki-1}$        $C_{ki-1}$        $M_{ki=1}$

i=1    (4.5)        ×        (1.5)        (6)

$TP_{pi-1}$        $C_{pi-1}$        $M_{pi-1=0}$

(5)        ×        (5)

$TP_{mi-1}$        $C_{mi-1}$        $M_{mi-1}$

(4)        ×        (1)        (5)

$TP_{\ell i-1}$        $C_{\ell i-1}$        $M_{\ell i-1}$

(1)    ×        ×        (3.5)        (4.5)

$C_{qi-1}$

×        (2)        (2)

$TP_{qi-1=0}$        $M_{qi-1}$

FIG. 5

$t_i$

(3.5) $TP_{ji}$    $C_{ji}$    $M_{ji}$

$i \rightarrow$

(4) $TP_{ki}$    $C_{ki}$    $M_{ki}$

(3) $TP_{pi}$    $C_{pi}$    $M_{pi}$

(3) $TP_{mi}$    $C_{mi}$    $M_{mi}$

(2.5) $TP_{\ell i}$    $C_{\ell i}$    $M_{\ell i}$

$TP_{qi}=0$    $C_{qi}$    $M_{qi}$

$TP_{ri}$    $C_{ri}$

$M_{ri}=0$

## FIG. 6

## FIG. 7

$V_{j1}$

VLIM

3.7
3.65
3.6
3.55
3.5
3.45
3.4

$t$

## FIG. 8

$V_{ji}$

VLIM

3.7
3.65
3.6
3.55
3.5
3.45
3.4

$t$

## RÉFÉRENCES CITÉES DANS LA DESCRIPTION

**Documents brevets cités dans la description**

- US 20020094623 A
- WO 2008009502 A